(19) Europäisches Patentamt
European Patent Office
Office européen des brevets

(11) EP 2 497 081 B1

(12) **EUROPÄISCHE PATENTSCHRIFT**

(45) Veröffentlichungstag und Bekanntmachung des Hinweises auf die Patenterteilung:
**16.10.2013 Patentblatt 2013/42**

(21) Anmeldenummer: **10771478.4**

(22) Anmeldetag: **02.11.2010**

(51) Int Cl.:
***G11B 7/245*** *(2006.01)* ***G11B 7/24*** *(2013.01)*

(86) Internationale Anmeldenummer:
**PCT/EP2010/066589**

(87) Internationale Veröffentlichungsnummer:
**WO 2011/054793 (12.05.2011 Gazette 2011/19)**

(54) **VERFAHREN ZUR HERSTELLUNG VON HOLOGRAPHISCHEN MEDIEN**

Method for producing holographic media

Procédé de fabrication de supports holographiques

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.11.2009 EP 09013765**

(43) Veröffentlichungstag der Anmeldung:
**12.09.2012 Patentblatt 2012/37**

(73) Patentinhaber: **Bayer Intellectual Property GmbH
40789 Monheim (DE)**

(72) Erfinder:
- **WEISER, Marc-Stephan
51379 Leverkusen (DE)**
- **RÖLLE, Thomas
51381 Leverkusen (DE)**
- **HÖNEL, Dennis
53909 Zülpich-Wichterich (DE)**
- **BRUDER, Friedrich-Karl
47802 Krefeld (DE)**
- **FÄCKE, Thomas
51375 Leverkusen (DE)**

(74) Vertreter: **BIP Patents
c/o Bayer Intellectual Property GmbH
Creative Campus Monheim
Alfred-Nobel-Straße 10
40789 Monheim (DE)**

(56) Entgegenhaltungen:
**WO-A-03/014178 WO-A-2008/125199**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein Verfahren zur Herstellung von holographischen Medien sowie nach dem Verfahren erhältliche holographische Medien.

Holographische Medien können beispielsweise mit Hilfe von speziellen Photopolymer-Formulierungen hergestellt werden. So ist etwa in der WO 2008/125199 A1 eine Photopolymer-Formulierung beschrieben, die Polyurethanbasierte Matrixpolymere, ein Schreibmonomer auf Acrylatbasis sowie Photoinitiatoren enthält. Härtet man die Photopolymer-Formulierung aus, sind in der dabei gebildeten Polyurethanmatrix das Schreibmonomer und die Photoinitiatoren räumlich isotrop verteilt eingebettet. Auf diese weise erhält man ein Medium, in das Hologramme einbelichtet werden können.

Dies kann mittels der Überlagerung zweier kohärenter Lichtquellen erfolgen, wobei sich eine dreidimensionale Struktur in dem Medium ausbildet, die sich im allgemeinen durch eine regionale Änderung des Brechungsindexes (Brechungsindexmodulation $\Delta n$) beschreiben lässt. Derartige Strukturen werden Hologramme genannt, die auch als diffraktive optische Elemente beschrieben werden können. Dabei hängt es von der speziellen Belichtung ab, welche optischen Funktionen ein solches Hologramm ausbildet.

Für die Verwendungen von Photopolymer-Formulierungen spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebenen Wellen) durch die lokale Photopolymerisation von z.B. hochbrechenden Acrylate an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz genannt, im folgenden DE wie Diffraction Efficiency. Im einfachsten Fall eines Hologramms, das aus der Überlagerung zweier ebener Wellen entsteht ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die Lichtmenge des Referenzlichtes die notwendig ist, um das Signal mit einer festen Helligkeit sichtbar zu machen.

Hochbrechende Acrylate sind in der Lage, Brechungsindexgitter mit hoher Amplitude zwischen Bereichen mit niedrigem Brechungsindex und Bereichen mit hohem Brechungsindex zu erzeugen und damit in Photopolymer-Formulierungen Hologramme mit hohem DE und hohem $\Delta n$ zu ermöglichen. Dabei ist zu beachten, dass DE vom Produkt aus $\Delta n$ und der Photopolymerschichtdicke d abhängt. Je größer das Produkt desto größer die mögliche DE (für Reflexionshologramme). Die Breite des Winkelbereiches bei dem das Hologramm z.B. bei monochromatischer Beleuchtung sichtbar wird (rekonstruiert) hängt nur von der Schichtdicke d ab. Bei Beleuchtung des Hologramms mit z.B. weißem Licht hängt die Breite des spektralen Bereiches der zur Rekonstruktion des Hologramms beitragen kann ebenfalls nur von der Schichtdicke d ab. Dabei gilt je kleiner d desto größer die jeweiligen Akzeptanzbreiten.

Will man helle und leicht sichtbare Hologramme herstellen, ist ein hohes $\Delta n$ und eine geringe Dicke d anzustreben und zwar so das DE möglichst groß wird. Das heißt je höher $\Delta n$ wird, desto mehr Freiraum zur Gestaltung der Schichtdicke d für helle Hologramme erreicht man ohne Verlust an DE. Daher kommt der Optimierung von $\Delta n$ bei der Optimierung von Photopolymerformulierungen eine herausragenden Bedeutung zu (P. Hariharan, Optical Holography, 2nd Edition, Cambridge University Press, 1996).

Es ist daher bisher versucht worden, durch Veränderung der Zusammensetzung der zur Herstellung der holographischen Medien verwendeten Photopolymer-Formulierungen ein möglichst hohes $\Delta n$ zu realisieren. Allerdings hat sich gezeigt, dass die im Laborversuch entwickelten Photopolymer-Formulierungen nicht ohne teils erhebliche Probleme für die großtechnische Herstellung von holographischen Medien eingesetzt werden können.

Ein derartiges großtechnisches Herstellungsverfahren ist beispielsweise in der noch nicht offengelegten europäischen Patentanmeldung mit der Anmeldenummer 09001952.2 beschrieben. Bei diesem Verfahren wird eine Photopolymer-Formulierung auf ein Trägermaterial aufgebracht und anschließend bei erhöhter Temperatur getrocknet. Auf diese Weise können holographische Medien in Form von Filmen erhalten werden.

Wenn die im Laborversuch für ein hohes $\Delta n$ optimierten Photopolymer-Formulierungen bei dem vorstehend beschriebenen Verfahren eingesetzt werden, erhält man in vielen Fällen Medien, die im Vergleich zu Medien, die im Labormaßstab hergestellt wurden, überraschenderweise deutlich niedrigere $\Delta n$ Werte aufwiesen, wenn in sie Hologramme geschrieben wurden. Es ist daher bisher nicht ohne weiters möglich, Laborformulierungen für die großtechnische Herstellung von holgraphischen Medien einzusetzen.

Aufgrund eines beobachteten Masseverlust bei der Herstellung der holographischen Medien liegt die Vermutung nahe, dass es während der Herstellung speziell im Bereich der Trocknung zur Verdampfung einzelner Komponenten kommen könnte. Unter Berücksichtigung der Siedepunkte und der Dampfdrücke der eingesetzten Komponenten konnte jedoch nicht erwartet werden, dass diese bei den jeweiligen Trocknungstemperaturen eine Ursache für den beobachteten Massenverlust und somit ein Grund für die deutlich niedrigeren $\Delta n$ Werte sein sollten.

Allerdings ist der Dampfdruck ein Parameter, mit dessen Hilfe die Eignung von Komponenten zur Verwendung bei der großtechnischen Herstellung von holographischen Medien nicht geprüft werden kann. Denn der Dampfdruck einer chemischen Verbindung ist eine Stoffkonstante, die beschreibt, wie ein Reinstoff oder ein Stoffgemisch im thermodynamischen Gleichgewicht mit seiner flüssigen oder festen Phase steht. Für dynamische Systeme liefert der Dampfdruck allerdings keine Anhaltpunkte.

So beschreibt der Dampfdruck nicht die Situation, wie sie zum Beispiel in einer kontinuierlich betriebenen Beschichtungsanlage herrscht. Hier wird die mit einer geringen Schichtdicke flächig auf eine Trägerfolie applizierte Photopolymer-Formulierung durch eine Luftumwälzung getrocknet. Die Luftumwälzung sorgt dafür, dass die gasförmige Phase konstant abgeführt wird. Ein thermodynamisches Gleichgewicht stellt sich somit unter diesen Bedingungen nicht ein.

Aufgabe der vorliegenden Erfindung war daher ein (großtechnisches) Verfahren anzugeben, mit dessen Hilfe holographische Medien mit einem hohen $\Delta$n hergestellt werden können.

Diese Aufgabe ist durch ein Verfahren zur Herstellung von holographischen Medien, bei dem

i) eine Photopolymer-Formulierung umfassend als Komponenten

A) Matrixpolymere

B) Schreibmonomere

C) Photoinitiatorsystem

D) optional eine nicht photopolymerisierbare Komponente

E) und gegebenenfalls Katalysatoren, Radikalstabilisatoren, Lösungsmittel, Additive sowie andere Hilfs- und / oder Zusatzstoffe

bereit gestellt,

ii) die Photopolymer-Formulierung flächig als Schicht auf eine Trägerfolie aufgebracht und

iii) die Photopolymer-Formulierung auf der Trägerfolie bei einer Temperatur 60 < T > 120 °C getrocknet wird,

dadurch gekennzeichnet, dass als Komponenten für die Photopolymer-Formulierung nur Verbindungen ausgewählt werden, deren TGA 95 Werte > 100 °C sind und mindestens 30 °C über der Temperatur T liegen, gelöst worden.

Um zu prüfen, ob bei einer bestimmten, in einer Photopolymer-Formulierung enthaltene Komponente, während eines Trocknungsprozesses an offnen Oberflächen die Gefahr besteht, dass diese aus der Formulierung herausdampft, ist also nicht deren Dampfdruck entscheidend. Vielmehr ist die der Flüchtigkeit dieser chemischen Komponente zu ermitteln, wobei hier als Maß der TGA 95 Wert genommen wird.

Unter dem TGA 95 Wert einer Komponenete im Sinne der vorliegenden Erfindung wird die Temperatur verstanden, bei der für die jeweilige Komponenete ein Massenverlust von 5 Gew.-%, bezogen auf die ursprünglich eingewogene Menge der Komponente, eingetreten ist. Der TGA 95 Wert der jeweiligen Komponente kann mit einer Thermogravimetrischen Analyse gemessen werden, bei der diese Temperatur bestimmt wird.

Die Eignung der TGA 95 Werte als Auswahlkriterium wird auch durch die folgenden experimentellen Befunde belegt: Für zwei zur Herstellung von holographischen Medien verwendete Komponenten, nämlich die Komponente D2 (2, 2, 3, 3, 4, 4, 5, 5, 6, 6, 7, 7, 8, 8, 9, 9- Hexadecafluornonyl- butylcarbamat) und Komponente D3 (2, 2, 2- Trifluorethylhexylcarbamat) wurden die Dampfdrücke unter Stickstoffatmosphäre in einer Umlaufapparatur (isobar in einem Ebulliometer) nach Röck gemäß der OECD Richtlinie zum Testen von Chemikalien Nr. 104 bestimmt. Die resultierenden Dampfdruckkurven sind im Temperaturbereich von 90 bis 180 °C in Figur 1 abgebildet. Die resultierenden Parameter der Antoine- Gleichung

$$\lg \frac{P^{Sat}}{hPa} = A - \frac{B}{C + T(°C)}$$

sind danach:

Tabelle 01: Stoffdaten der Komponenten D2 und D3

| Beispiel | Parameter der Antoine-Gleichung | | | Dampfdruck bei 80 °C [hPa] | Dampfdruck bei 100 °C [hPa] | TGA 95 [°C] |
|---|---|---|---|---|---|---|
| | A | B | C | | | |
| D2 | 6.5466 | 1053.404 | 42.458 | 0.13 | 0.42 | 111.8 |
| D3 | 15.6189 | 2616.075 | 90.3596 | 1.30 | 7.30 | 72.5 |

Hieraus ergibt sich, dass der Gleichgewichtsdampfdruck für eine Temperatur von beispielsweise 100 °C für beide Komponenten D2 und D3 < 10 hPa ist, so dass man erwartet hätte, dass die beiden Komponenten in der Formulierung eine ausreichende Beständigkeit hätten. Dies ist jedoch nicht der Fall. Die TGA 95 Werte der beiden Komponenten D2 und D3 korrelieren dagegen deutlich besser mit dem beobachteten Verhalten und zeigen, dass beide Verbindungen nicht zur Herstellung von holographischen Medien in einem erfindungsgemäßen Verfahren geeignet sind.

Die TGA 95 Werte der einzelnen Komponenten können insbesondere bestimmt werden , indem eine Menge der Probe der jeweiligen Komponente von ca. 10 mg in ein Aluminiumpfännchen mit einem Volumen von 70 μl eingewogen, das Aluminiumpfännchen in einen Ofen einer Thermowaage, bevorzugt einer Thermowaage TG50 der Firma Mettler-Toledo, eingebracht und bei einer konstanten Aufheizrate des Ofens von 20 K/min der Massenverlust der Probe im offenen Aluminiumpfännchen gemessen wird, wobei die Starttemperatur 30 °C und die Endtemperatur 600 °C des Ofens betragen, der Ofen während der Bestimmung mit einem Stickstoffstrom einer Stärke von 200 ml/min durchgespült und als TGA 95 Wert der jeweiligen Komponente die Temperatur ermittelt wird, bei der ein Massenverlust der Probe von 5 Gew.-%, bezogen auf die ursprünglich eingewogene Menge der Probe, eingetreten ist.

Vorzugsweise kann die die Photopolymer-Formulierung bei einer Temperatur 70 < T < 100 °C getrocknet werden.

Bei den verwendeten Matrixpolymeren kann es sich vorzugsweise um Polyurethane handeln, die insbesondere durch Umsetzung von einer Isocyanatkomponente a) mit einer Isocyanat-reaktiven Komponente b) erhältlich sind.

Die Isocyanatkomponente a) umfasst bevorzugt Polyisocyanate. Als Polyisocyanate können alle dem Fachmann an sich bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1, 8- Diisocyanato- 4- (isocyanatomethyl)- octan, 2, 2, 4- und/ oder 2, 4, 4- Trimethylhexamethylendiisocyanat, die isomeren Bis- (4, 4'- isocyanatocyclohexyl) methan und deren Mischungen beliebigen Isomerengehalts, Isocyanatomethyl- 1, 8- octandiisocyanat, 1, 4- Cyclohexylendiisocyanat, die isomeren Cyclohexandimethylendiisocyanate, 1, 4- Phenylendiisocyanat, 2, 4- und/ oder 2, 6- Toluylendiisocyanat, 1, 5- Naphthylendiisocyanat, 2, 4'- oder 4, 4'- Di- phenylmethandiisocyanat und/ oder Triphenylmethan- 4, 4', 4"- triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/ oder Iminooxadiazindione basierend auf HDI sowie 1, 8- Diisocyanato- 4- (isocyanatomethyl)- octan oder deren Mischungen.

Ebenfalls können als Komponente a) NCO-funktionelle Prepolymere mit Urethan-, Allophanat-, Biuret- und/ oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl- hexamethylen- diisocyanat (TMDI), 1, 8- Diisocyanato- 4- (isocyanatomethyl)- octan, Isocyanatomethyl- 1, 8- octandiisocyanat (TIN), 2, 4- und/ oder 2, 6- Toluen- diisocyanat.

Als isocyanatreaktive Verbindungen a2) zum Aufbau der Prepolymere werden bevorzugt OH-funktionellen Verbindungen eingesetzt. Diese sind analog den OH-funktionellen Verbindungen wie sie nachfolgend für die Komponente b) beschrieben sind.

Allophanate können auch im Gemisch mit anderen Prepolymeren oder Oligomeren der Komponente a1) eingesetzt werden. In diesen Fällen ist der Einsatz von OH-funktionellen Verbindungen mit Funktionalitäten von 1 bis 3,1 vorteilhaft. Beim Einsatz monofunktioneller Alkohole sind solche mit 3 bis 20 Kohlenstoffatomen bevorzugt.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art. Beispiele sind aliphatische Biurete auf Basis aliphatischer Amine und aliphatischer Isocyanate, insbesondere HDI und TMDI.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol.

Bevorzugt weisen die vorstehend beschriebenen Prepolymere Restgehalte an freiem monomeren Isocyanat von weniger als 2 Gew.-%, besonders bevorzugt weniger als 1,0 Gew.-%, ganz besonders bevorzugt weniger als 0,5 Gew.-% auf.

Selbstverständlich kann die Isocyanatkomponente anteilsmäßig neben den beschriebenen Prepolymeren weitere Isocyanatkomponenten enthalten. Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1, 2, 4- Triazol, Dimethyl- 1, 2, 4- triazol, Imidazol, Malonsäurediethylester, Acetessigester, Acetonoxim, 3, 5-Dimethylpyrazol, ε- Caprolactam, N- tert.- Butyl- benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1,5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly (meth) acrylat- und/ oder Polyurethanpolyole.

Daneben sind als Bestandteile der Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1, 2- Propandiol, 1, 3- Propandiol, 1, 4- Butandiol, Neopentylglykol, 2- Ethyl- 2- butylpropandiol, Trimethylpentandiol, stellungsisomere Diethyloctandiole, 1, 3- Butylenglykol, Cyclohexandiol, 1, 4- Cyclohexandimethanol, 1, 6- Hexandiol, 1, 2- und 1, 4- Cyclohexandiol, hydriertes Bisphenol A (2, 2- Bis (4- hydroxycyclohexyl) propan), 2, 2- Dimethyl- 3- hydroxypropionsäure (2, 2- dimethyl- 3- hydroxypropylester) . Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität $\geq 2$ erhalten werden. Bevorzugte Polyesterpolyole basieren auf aliphatischen Alkoholen und Mischungen aus aliphatischen und aromatischen Säuren und haben zahlenmittlere Molmassen zwischen 500 und 10000 g/Mol und Funktionalitäten zwischen 1,8 und 6,1.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen im Rahmen einer ringöffnenden Lacton-Polymerisation wie Butyrolacton, ε-Caprolacton und/oder Methyl-ε-caprolacton an hydroxyfunktionelle Verbindungen wie mehrwertige Alkohole einer OH-Funktionalität ≥ 2 oder Polyole eine Funktionalität von größer 1,8 beispielsweise der vorstehend genannten Art erhalten werden können.

Beispiele für hier als Starter eingesetzte Polyole sind Polyetherpolyole einer Funktionalität von 1, 8 bis 3, 1 mit zahlenmittleren Molmassen von 200 bis 4000 g/mol, bevorzugt sind Poly (tetrahydrofurane) mit einer Funktionalität von 1, 9 bis 2, 2 und zahlenmittleren Molmassen von 500 bis 2000 g/mol. Als Anlagerungsprodukte sind Butyrolacton, ε-Caprolacton und/ oder Methyl- ε- caprolacton, ε- Caprolacton ist besonders bevorzugt.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH- Funktionalität ≥ 2, bevorzugt 1, 4- Butandiol, 1, 6- Hexandiol und/ oder 3- Methylpentandiol, oder auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle-Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen- umfasst hierbei alle jeweiligen linearen und verzweigten C3- und C4-Isomere.

Als spezielle Polyetherpolyole werden bevorzugt solche eingesetzt, die aus einer isocyanatreaktiven Komponente umfassend hydroxyfunktionelle Multiblockcopolymere des Typs Y (Xi- H) n mit i = 1 bis 10 und n = 2 bis 8 und zahlenmittleren Molekulargewichten von größer 1500 g/Mol bestehen, wobei die Segmente Xi jeweils aus Oxyalkyleneinheiten der Formel (I) aufgebaut sind,

- CH2- CH (R)- O- Formel (I)

wobei R ein Wasserstoff-, Alkyl-, oder Arylrest, ist, der auch substituiert oder durch Heteroatome (wie Ethersauerstoffe) unterbrochen sein kann, Y der zugrundeliegende Starter ist und der Anteil der Segmente Xi bezogen auf die Gesamtmenge der Segmente Xi und Y wenigstens 50 Gew.- % ausmacht.

In Formel (I) ist R bevorzugt ein Wasserstoff, eine Methyl-, Butyl-, Hexyl- oder Octylgruppe oder ein ethergruppenhaltiger Alkylrest. Bevorzugte ethergruppenhaltiger Alkylreste sind solche basierend auf Oxyalkyleneinheiten.

Die Multiblockcopolymere $Y(X_i\text{-}H)_n$ haben bevorzugt zahlenmittlere Molekulargewichte von mehr als 1200 g/Mol, besonders bevorzugt mehr als 1950 g/Mol, jedoch bevorzugt nicht mehr als 12000 g/Mol, besonders bevorzugt nicht mehr als 8000 g/Mol.

Bevorzugt eingesetzte Blockcopolymere der Struktur $Y(X_i\text{-}H)_n$ bestehen zu mehr als 50 Gewichtsprozent aus den oben beschriebenen Blöcken $X_i$ und haben eine zahlenmittlere Gesamtmolmasse von größer 1200 g/Mol.

Bevorzugte Kombinationen aus Komponente a) und b) bei der Herstellung der Matrixpolymere sind:

A) Additionsprodukte von Butyrolacton, ε-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Besonders bevorzugt Additionsprodukte von ε-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

B) Polyetherpolyole mit zahlenmittlere Molmassen von 500 bis 8500 g/Mol und OH-Funktionalitäten von 1,8 bis 3,2, ausschließlich basierend auf Propylenoxid oder statistische oder Block-Copolyole basierend auf Propylenoxid und Ethylenoxid, wobei der Ethylenoxidanteil nicht höher als 60 Gew.-% ist in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol. Besonders bevorzugt sind Propylenoxid-homopolymere mit zahlenmittlere Molmassen von 1800 bis 4500 g/Mol und OH-Funktionalitäten von 1,9 bis 2,2 in Verbindung mit Allophanaten aus HDI oder TMDI und difunktionellen Polyetherpolyolen (insbesondere Polypropylenglykolen) mit zahlenmittleren Molmassen von 200 bis 2100 g/Mol.

C) Polyetherblock- oder -multiblockcopolymere der Formel (I), wobei Y ein rein aliphatisches Polycarbonatpolyol oder ein Polymer des Tetrahydrofurans mit jeweils einer OH-Funktionalität von 1,8 bis 3,1 und einer zahlenmittlere Molmassen von 400 bis 2000 g/Mol ist, n = 2, i = 1 oder 2 und R = Methyl oder H ist, mit einer gesamten zahlenmittleren Molmasse von 1950 bis 9000 g/mol in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol oder in Verbindung mit Isocyanuraten, Uretdionen, Iminooxadiazindionen und/oder anderen Oligomeren basierend auf HDI. Besonders bevorzugt sind Polyetherblock- oder -multiblockcopolymere der Formel (I), wobei Y ein rein aliphatisches Polycarbonatpolyol auf Basis 1,4-Butandiol und/oder 1,6-Hexandiol mit Dimethyl- oder Diethylcarbonat oder ein Polymer des Tetrahydrofurans mit einer OH-Funktionalität von 1,8 bis 2,2 und einer zahlenmittlere Molmassen von 600 bis 1400 g/Mol (insbesondere bis 1000 g/Mol) ist, n = 2, i = 1 oder 2 und R = Methyl oder H ist, wobei der Anteil der Ethylenoxideinheiten an der Gesamtmasse von $X_i$ nicht höher als 60 Gew.-% ist, in Verbindung mit Allophanaten aus HDI oder TMDI und difunktionellen Polyetherpolyolen (insbesondere Polypropylenglykolen) mit zahlenmittleren Molmassen von 200 bis 2100 g/Mol, in Verbindung mit Biureten mit zahlenmittleren Molmassen von 200 bis 1400 g/Mol (insbesondere auch im Gemisch mit anderen Oligomeren difunktioneller aliphatischer Isocyanate) basierend auf aliphatischer Diaminen oder Polyaminen und aliphatischen Diisocyanaten, insbesondere HDI und TMDI, in Verbindung mit Urethanen aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 200 bis 3000 g/Mol, insbesondere bevorzugt von 1000 bis 2000 g/Mol (insbesondere im Gemisch mit anderen Oligomeren difunktioneller aliphatischer Isocyanate) oder in Verbindung mit Isocyanuraten, Iminooxadiazindionen und/oder anderen Oligomeren basierend auf HDI.

Als Komponente B) werden ein oder mehrere verschiedene Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind, eingesetzt. Bevorzugt sind die Schreibmonomere Acrylate und / oder Methacrylate.

In Komponente B) können Verbindungen wie α, β- ungesättigte Carbonsäurederivate wie Acrylate, Methacrylate, Maleinate, Fumarate, Maleimide, Acrylamide, weiterhin Vinylether, Propenylether, Allylether und Dicyclopentadienyl- Einheiten enthaltende Verbindungen sowie olefinisch ungesättigte Verbindungen wie z.B. Styrol, α- Methylstyrol, Vinyltoluol, Olefine, wie z.B. 1- Octen und/ oder 1- Decen, Vinylestern, (Meth) acrylnitril, (Meth) acrylamid, Methacrylsäure, Acrylsäure eingesetzt werden. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n- Butylacrylat, n- Butylmethacrylat, tert.- Butylacrylat, tert- Butylmethacrylat, Hexylacrylat, Hexylmethacrylat, 2- Ethylhexylacrylat, 2- Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p- Chlorphenylacrylat, p- Chlorphenylmethacrylat, p- Bromphenylacrylat, p- Bromphenyl- methacrylat, 2, 4, 6- Trichlorphenylacrylat, 2, 4, 6- Trichlorphenylmethacrylat, 2, 4, 6- Tribromphenyl- acrylat, 2, 4, 6- Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, 2- Naphthylacrylat, 2- Naphthylmethacrylat, 1, 4- Bis- (2- thionaphthyl)- 2- butylacrylat, 1, 4- Bis- (2- thionaphthyl)- 2- butylmethacrylat, Propan- 2, 2- diylbis[(2, 6- dibrom- 4, 1- phenylen) oxy (2- { [3, 3, 3- tris (4- chlorphenyl)- propanoyl]- oxy} propan- 3, 1- diyl) oxyethan- 2, 1- diyl]- diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N- Carbazolylacrylate um nur eine Auswahl verwendbarer Acrylate und Methacrylate zu nennen.

Selbstverständlich können auch Urethanacrylate als Komponente B) verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Bevorzugt werden dabei Acrylate und Methacrylate mit einem Brechungsindex $n_D^{20}$ (gemessen bei einer Wellenlänge von 405 nm) von größer 1,450 eingesetzt. Besonders bevorzugt werden Acrylate eingesetzt, die mindestens

eine aromatische Struktureinheit enthalten und einen Brechungsindex $n_D^{20}$ (405 nm) von größer 1,500 haben. Als besonders geeignete Beispiele hierfür sind Acrylate und Methacrylate auf Basis von Bisphenol A oder dessen Derivate zu nennen sowie solche Acrylate und Methacrylate, die eine Thioarylgruppe enthalten.

Beispiele für die als Komponente B) verwendeten Urethanacrylate und/ oder Urethanmethacrylate sind die Additionsprodukte aromatischer Triisocyanate (ganz besonders bevorzugt Tris- (4- phenylisocyanato)- thiophosphat oder Trimere aromatischer Diisocyanate wie Toluylendiisocyanat) mit Hydroxyethylacrylat, Hydroxypropylacrylat, 4-Hydroxybutylacrylat, die Additionsprodukte von 3- Thiomethyl- phenylisocyanat mit Hydroxyethylacrylat, Hydroxypropylacrylat, 4- Hydroxy- butylacrylat sowie ungesättigte Glycidyletheracrylaturethane (wie in den Anmeldungen WO 2008/125229 A1 und in der nicht vorveröffentlichten Anmeldung EP 09009651.2 beschrieben) oder deren beliebige Mischungen untereinander.

Weiterhin ist die Verwendung von Glycidyletheracrylaturethanen als Schreibmonomere bevorzugt. Diese gehorchen der allgemeinen Formel (IIa) oder (IIb) oder Mischungen aus (IIa) und (IIb)

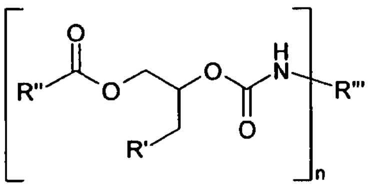

(IIa)

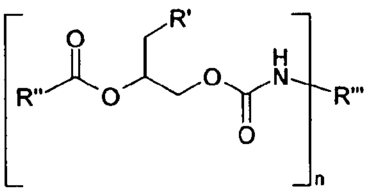

(IIb)

wobei

- n eine natürliche Zahl von 2 bis 6 ist
- R' ein ein- oder mehrkerniger Aromatengruppen haltiger organischer Rest mit 4 bis 36 Kohlenstoffatomen ist,
- R" ein olefinisch ungesättigter Rest mit 3 bis 30 Kohlenstoffatomen ist und
- R"' ein von einem aliphatischen oder aromatischen Di- oder Polyisocyanat abgeleiteter organischer Rest mit 2 bis 30 Kohlenstoffatomen ist.

Die ungesättigten Glycidyletheracrylaturethane der Formel IIa bzw. IIb können in einer 2- Stufen Synthese hergestellt werden. In der ersten Umsetzung wird eine ungesättigte Carbonäure mit einem Epoxid zur Reaktion gebracht, wobei ein Gemisch zweier Alkohole gebildet wird. Selbstverständlich können in diesem Reaktionsschritt auch ungesättigte Epoxide mit beliebigen Carbonsäuren zum analogen Zwischenprodukt umgesetzt werden. In einem zweiten Reaktionsschritt wird dieses Alkoholgemisch mittels eines Di- oder Polyisocyanats R"' $(NCO)^n$ der Funktionalität n zum Glycidyletheracrylaturethan urethanisiert (wie in der nicht vorveröffentlichten Anmeldung EP 09002180.9 beschrieben) . Bevorzugt werden dabei Methacrylsäure und Acrylsäure oder deren Derivate bzw. aromatische Carbonsäuren für die Umsetzung mit einem ungesättigten Epoxid eingesetzt, als Epoxide finden bevorzugt aromatische oder ungesättigte Epoxide wie Phenyl-, Dibromophenyl-, Naphthyl- oder Biphenylglycidether oder Glydidyl (meth) acrylat Anwendung und als Isocyanatkomponente verwendet man bevorzugt Toluolyldiisocyanat (TDI), Hexamethylendiisocyanat (HDI) oder Triisocyanatononan (TIN) .

In einer ganz besonders bevorzugten Ausführungsform werden die Kombinationen aus (Acrylsäure, Biphenylglycidether und TDI), (Acrylsäure, Phenylglycidether und TDI) sowie (Acrylsäure, Biphenyglycidether und HDI) verwendet.

Eine weitere bevorzugte Ausführungsform sieht vor, dass als Schreibmonomere eine Kombination aus einem monofunktionellen und einem multifunktionellen Schreibmonomer verwendet wird.

Das monofunktionelle Schreibmonomer kann insbesondere die allgemeine Formel (II)

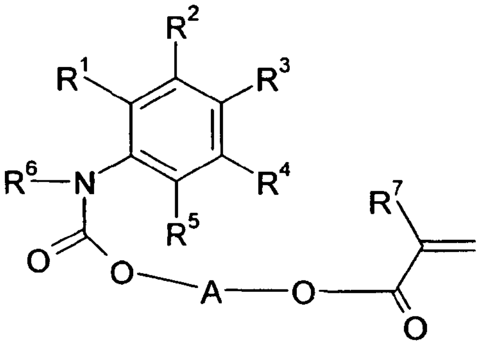

(II)

haben, in der $R^1$, $R^2$, $R^3$, $R^4$, $R^5$ jeweils unabhängig voneinander ein Wasserstoff- oder Halogenatom oder eine C1- C6- Alkyl-, Trifluormethyl-, C1- C6- Alkylthio-, C1- C6- Alkylseleno-, C1- C6- Alkyltelluro- oder Nitro- Gruppe sind, mit der Maßgabe dass wenigstens ein Substituent der Gruppe $R^1$, $R^2$, $R^3$, $R^4$, $R^5$ nicht Wasserstoff ist, $R^5$, $R^7$ jeweils für sich Wasserstoff oder eine C1- C6- Alkylgruppe sind und A ein gesättigter oder ungesättigter oder linearer oder verzweigter C1- C6- Alkyl- Rest oder ein Polyethylenoxid- Rest oder ein Polypropylenoxid- Rest mit jeweils 2- 6 Widerholungseinheiten in der Polymerkette ist, und das monofunktionelle Schreibmonomer bevorzugt eine Glastemperatur $T_G$ < 0°C und bevorzugt einen Brechungsindex >1.50 bei 405 nm aufweist.

Das multifunktionelle Schreibmonomer kann insbeondere die allgemeine Formel (III)

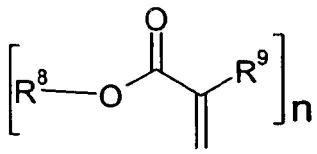

(III)

haben, in der n≥2 und n≤4 ist und $R^8$, $R^9$ Wasserstoff und / oder unabhängig voneinander lineare, verzweigte, cyclische oder heterocyclische unsubstituierte oder gegebenenfalls auch mit Heteroatomen substituierte organische Reste sind. Weiterhin kann das multifunktionelle Schreibmonomer bevorzugt einen Brechungsindex >1.50 bei 405 nm aufweisen.

Als Komponente C) werden ein oder mehrere Photoinitiatoren eingesetzt. Das verwendete Photoinitiatorsystem kann vorzugsweise einen anionischen, kationischen oder neutralen Farbstoff und einen Coinitiator umfassen. Beispiele sind Mischungen aus Tetrabutylammonium Triphenylhexylborat, Tetrabutylammonium Triphenylbutylborat, Tetrabutylammonium Trinapthylbutylborat, Tetrabutylammonium Tris- (4- tert.- butyl)- phenylbutylborat, Tetrabutylammonium Tris- (3- fluorphenyl)- hexylborat und Tetrabutylammonium Tris- (3- Chlor- 4- methylphenyl)- hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Weitere Bestandteile der Photopolymer-Formulierung können sein (Komponenten E)): Radikalstabilisatoren, gegebenenfalls Katalysatoren oder andere Hilfs- und Zusatzstoffe.

Als Beispiele für Radikalstabilisatoren sind Inhibitoren und Antioxidantien wie sie z.B. in "Methoden der organischen Chemie" (Houben- Weyl), 4. Auflage, Band XIV/ 1, S. 433ff, Georg Thieme Verlag, Stuttgart 1961, beschrieben sind, geeignet. Geeignete Stoffklassen sind beispielsweise Phenole wie z.B. 2, 6- Di- tert- butyl- 4- methylphenol, Kresole, Hydrochinone, Benzylalkohole wie z.B. Benzhydrol, ggf. auch Chinone wie z. B. 2, 5- Di- *tert.*- Butylchinon, ggf. auch aromatische Amine wie Diisopropylamin oder Phenothiazin.

Bevorzugt sind 2, 6- Di- *tert.*- butyl- 4- methylphenol, Phenothiazin, p- Methyoxyphenol, 2- Methoxy- p- hydrochinon und Benzhydrol.

Gegebenenfalls können ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1- oxoneodecyl) oxy] stannan, Dimethylzinndicarboxylat, Zirkonium- bis (ethylhexanoat), Zirconium- acteylacetonat oder tertiäre Aminen wie beispielsweise 1, 4- Diazabicyclo [2.2.2] octan, Diazabicyclononan, Diazabicycloundecan, 1, 1, 3, 3- Tetramethylguanidin, 1, 3, 4, 6, 7, 8- Hexahydro- 1- methyl- 2H- pyrimido (1, 2- a) pyrimidin.

Bevorzugt sind Dibutylzinndilaurat, Dimethylbis[(1- oxoneodecyl) oxy] stannan, Dimethylzinndicarboxylat, 1, 4- Diazabicyclo [2.2.2] octan, Diazabicyclononan, Diazabicycloundecan, 1, 1, 3, 3- Tetramethylguanidin, 1, 3, 4, 6, 7, 8- Hexahydro- 1- methyl- 2H- pyrimido (1, 2- a) pyrimidin.

Selbstverständlich können gegebenenfalls weitere Hilfs- oder Zusatzstoffe eingesetzt werden. Dabei kann es

sich beispielsweise um im Bereich der Lacktechnologie gängige Zusatzstoffe wie Lösemittel, Weichmacher, Verlaufsmittel oder Haftvermittler handeln. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Bevorzugt ist vorgesehen, dass die Photopolymer-Formulierung spezielle nicht photopolymerisierbare Additive enthält (Komponente D). Bei diesen Additiven kann es sich insbesondere um Urethane und / oder fluorierte Urethane handeln.

Bevorzugt können die Urethane die allgemeine Formel (IV)

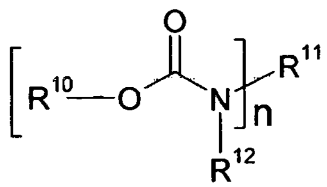

(IV)

haben, in der n≥1 und n≤8 ist und $R^{10}$, $R^{11}$, $R^{12}$ Wasserstoff und / oder unabhängig voneinander lineare, verzweigte, cyclische oder heterocyclische unsubstituierte oder gegebenenfalls auch mit Heteroatomen substituierte organische Reste sind, wobei bevorzugt mindestens einer der Reste $R^{10}$, $R^{11}$, $R^{12}$ mit wenigstens einem Fluoratom substituiert ist und besonders bevorzugt $R^{10}$ ein organischer Rest mit mindestens einem Fluoratom ist.

Die Fluorurethane können einen Fluorgehalt von 10-80 Gew.-% Fluor, bevorzugt von 13-70 Gew.-% Fluor und besonders bevorzugt 17,5-65 Gew.-% Fluor aufweisen.

Ein Film aus der Photopolymer-Formulierung kann beispielsweise mit Hilfe einer Rollenbeschichtungsanlage auf eine Trägerfolie aufgebracht werden.

Dies kann durch eine Kombination verschiedener Prozessschritte erfolgen, bei denen dem Fachmann bekannte Zwangsdosierpumpen, Vakuumentgaser, Plattenfilter, Statische Mischer, Schlitzdüsen oder verschiedene Rakelsysteme, Ein-Rollenabwickler, Lufttrockner, Trockenkaschiereinrichtung und eine Ein-Rollenaufwickeleinrichtung, eingesetzt werden. Speziell eine Beschichtungseinrichtungen, die z.B. Schlitzdüsen und Rakelsysteme aufweisen, sind für die Applikation von flüssigen Photopolymer-Formulierungen auf bewegende Trägermaterialien geeignet und zeichnen sich durch eine hohe Genauigkeit in der Applikationsschichtdicke aus.

In einer bevorzugten Ausführungsform umfasst der Beschichtungsprozess der Trägerfolie die nachfolgenden Einzelschritte zur Behandlung vorgenannten Photopolymer-Formulierungen:

I. Fördern und Dosieren zum einen der Komponente a) gegebenenfalls gemischt mit einer oder mehrerer der Komponenten B), C), D) und E) sowie zum anderen separat dazu der Komponente b) gegebenenfalls gemischt mit einer oder mehrerer der Komponenten B), C), D) und E)

II. Entgasen der gemäß I) geförderten, dosierten und gegebenenfalls vorvermischten Ströme

III. Filtrieren der nach II) erhaltenen Mischung

IV. Homogenisieren der nach III) erhaltenen Mischung

V. Abwicklung und Vorbehandlung der Trägerfolie

VI. Beschichten der Trägerfolie mit der nach Schritt IV) erhaltenen Mischung

VII. Trocknung des nach VI) beschichteten Films

VIII. Kaschieren des nach VII) erhaltenen beschichteten Films

IX. Aufwicklung des nach VIII) erhaltenen kaschierten Films

In einer besonders bevorzugten Ausführung erfolgt dabei die Dosierung der Einsatzstoffe entweder durch Zahnrad- oder Excenterschneckenpumpen. Zur Entgasung der Einsatzstoffe werden Zentrifugalentgaser und zur Filterung Plattenfilter eingesetzt. Die Mischung der Einzelkomponenten erfolgt über einen statischen Mischer mit entsprechend ausgelegten Mischgeometrien, wie z.B. Länge und Durchmesser. Als bevorzugte Beschichtungseinheit wird eine Schlitzdüse eingesetzt. Das beschichtete Material wird über Lufttrockner mit der gewünschten Lufttemperatur und

Feuchtgehalt über einen definierten Zeitraum getrocknet.

Figur 1 zeigt einen schematischen Aufbau einer typischen Beschichtungsanlage, inklusive Anordnung der Vorbehandlung des Beschichtungsmaterials (1-5), schematischer Verlauf des Trägerfolie (8 + 9), Beschichtungseinrichtung zum Applizieren auf die Trägerfolie (6) und anschließenden Trocknungsprozess (7).

In der Figur 2 stehen die Bezugszeichen für die folgenden Bauteile:

1 Vorratsbehälter

2 Dosiereinrichtung

3 Vakuumentgasung

4 Filter

5 Statischer Mischer

6 Beschichtungseinrichtung

7 Trockner

8 Bahnlauf

9 Produkt-Kaschierung

Durch die Kombination der beschriebenen Prozessschritte wie in Figur 2 dargestellt, können Photopolymer-Formulierungen auf sich bewegende Trägermaterialien in einer hohen Schichtdickengenauigkeit appliziert werden.

Gemäß einer weiteren bevorzugten Ausführungsform können die holographischen Medien Folienverbunde sein, die aus einer oder mehreren Trägerfolien, einer oder mehreren Photopolymerschichten und einer oder mehrer Schutzfolien in beliebiger Anordnung bestehen können.

Bevorzugte Materialien oder Materialverbünde der Trägerschicht basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Daneben können Materialverbünde wie Folienlaminate oder Coextrudate als Trägerfolie Anwendung finden. Beispiele für Materialverbünde sind Duplex- und Triplexfolien aufgebaut nach einem der Schemata A/B, AB/A oder A/B/C wie PC/PET, PET/PC/PET und PC/TPU (TPU = Thermoplastisches Polyurethan). Besonders bevorzugt wird PC und PET als Trägerfolie verwendet.

Zusätzlich zu den Bestandteilen und können für den Folienverbund ein oder mehrere Abdeckschichten auf der Photopolymerschicht aufweisen, um diese vor Schmutz und Umwelteinflüssen zu schützen. Hierzu können Kunststofffolien oder Folienverbundsysteme, aber auch Klarlacke verwendet werden.

Außerdem können weitere Schutzschichten, so z.B. eine untere Kaschierung der Trägerfolie Anwendung finden.

Ein weiterer Gegenstand der Erfindung ist ein nach dem erfindungsgemäßen Verfahren erhältliches holographisches Medium.

**<u>Beispiele:</u>**

Die folgenden Beispiele dienen zur Erläuterung der Erfindung. Sofern nicht abweichend vermerkt beziehen sich alle Prozentangaben auf Gewichtsprozent.

**<u>Bezeichnungen die im folgenden Verwendung finden:</u>**

Photopolymer- Formulierungen umfassend:

- Dreidimensional vernetzte Matrixpolymere A). Besonders bevorzugt sind solche dreidimensional vernetzte organische Polymere, welche als Vorstufen aus

  o einer Isocyanatkomponente a)

  o und einer Isocyanat-reaktiven Komponente b) aufgebaut sind und

o mit Hilfe einer Katalysator Komponente E) vernetzt werden, der in der Regel in Lösung zugegeben wird,

- Schreibmonomere B), die unter Einwirkung aktinischer Strahlung mit ethylenisch ungesättigten Verbindungen unter Polymerisation reagierende Gruppen (strahlenhärtende Gruppen) aufweisen und in dieser Matrix gelöst oder verteilt vorliegen

- wenigstens einen Photoinitiatorsystem C).

- optional eine nicht photopolymerisierbare Komponente D).

- gegebenenfalls Katalysatoren, Radikalstabilisatoren, Lösungsmittel, Additive sowie andere Hilfs- und / oder Zusatzstoffe E)

**<u>Einsatzstoffe</u>**

**Verwendete isocyanate (Komponenten a)**

Isocyanatkomponente 1 (Komponente a1) ist ein Versuchsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %
Isocyanatkomponente 2 (Komponente a2) ist ein Versuchsprodukt der Bayer MateriaiScience AG, Leverkusen, Deutschland, Vollallophanat von Hexandiisocyanat auf Polypropylenglykol mit zahlenmittlerer Molmasse von ca. 280 g/mol, NCO-Gehalt: 16,5 - 17,3 %.
Isocyanatkomponente 3 (Komponente a3) ist ein Handelsprodukt der Bayer MaterialScience AG, Leverkusen, Deutschland, Mischung aus 29, 4 mol- % Isocyanurats auf Basis von HDI mit 70, 6 mol% des Urethans aus Poly (ε-Caprolacton) der zahlenmittleren Molmasse 650 g/Mol mit HDI, NCO- Gehalt 10, 5- 11, 5 %.

**Verwendete isocyanatreaktiven Komponenten (Komponente b)**

Polyol 1 (Komponente b1) ist ein experimentelles Produkt der Bayer MaterialScience AG, Leverkusen, Deutschland, die Herstellung ist unten beschrieben.
Polyol 2 (Komponente b2) ist ein experimentelles Produkt der Bayer MaterialScience AG, Leverkusen, Deutschland, die Herstellung ist unten beschrieben.
Polyol 3 (Komponente b3) ist ein experimentelles Produkt der Bayer MaterialScience AG, Leverkusen, Deutschland, die Herstellung ist unten beschrieben.
Terathane® 650 ist ein Handelsprodukt der Fa. BASF SE, Ludwigshafen, Deutschland (Poly- THF der Molmassen 650 g/Mol) .

**Verwendete strahlenhärtende Verbindung (Komponente B)**

Acrylat 1 (Komponente B1) ist ein experimentelles Produkt der Bayer MaterialScience AG, Leverkusen, Deutschland, die Herstellung ist unten beschrieben.
Acrylat 2 (Komponente B2) ist ein experimentelles Produkt der Bayer MaterialScience AG, Leverkusen, Deutschland, die Herstellung ist unten beschrieben.
Acrylat 3 (Komponente B3) ist ein experimentelles Produkt der Bayer MaterialScience AG, Leverkusen, Deutschland, die Herstellung ist unten beschrieben.

**Verwendete Komponenten der Photoinitiatorsysteme (Komponente C)**

Coinitiator 1 Tetrabutylammonium- tris (3- chlor- 4- methylphenyl) (hexyl) borat, [1147315- 11- 4] ) ist ein von der Ciba Inc., Basel, Schweiz, hergestelltes Versuchsprodukt.
Farbstoff 1 ist Neu Methylenblau (CAS 1934-16-3) und wurde von SIGMA-ALDRICH CHEMIE GmbH, Steinheim, Deutschland bezogen.
Farbstoff 2 ist Safranin O (CAS 477-73-6) und wurde von SIGMA-ALDRICH CHEMIE GmbH, Steinheim, Deutschland bezogen..
Farbstoff 3 ist Ethylviolett (CAS 2390-59-2) und wurde in 80%-iger Reinheit von SIGMA-ALDRICH CHEMIE GmbH, Steinheim, Deutschland bezogen und so eingesetzt.
Farbstoff 4 ist Astrazon Orange G (CAS 3056-93-7) und wurde von SIGMA-ALDRICH CHEMIE GmbH, Steinheim, Deutschland bezogen.

**Verwendete nicht photopolymerisierbare Komponenten (Komponente D)**

Die nicht photopolymerisierbaren Komponenten (Komponente D1 bis D10) sind experimentelle Produkte der Bayer MaterialScience AG, Leverkusen, Deutschland, deren Herstellung ist unten beschrieben.

**Verwendeter Katalysator (Komponente E)**

Katalysator 1 (Komponente E1) : Urethanisierungskatalysator, Dimethylbis[(1- oxoneodecl) oxy] stannan, Handelsprodukt der Momentive Performance Chemicals, Wilton, CT, USA (als 10%ige Lösung in N- Ethylpyrrolidon eingesetzt) .

**Verwendete Hilfs- und Zusatzstoffe (Komponente E)**

BYK 310: silikonbasiertes Oberflächenadditiv der Fa. BYK-Chemie GmbH, Wesel, Deutschland (Komponente E2) (Lösung 25%-ig in Xylol)
DMC- Katalysator: Doppelmetallcyanid- Katalysator auf Basis Zinkhexacyanocobaltat (III), erhältlich nach dem in EP- A 700 949 beschriebenen Verfahren.
Irganox 1076 ist Octadecyl 3, 5- di- (tert)- butyl- 4- hydroxyhydrocinnamate (CAS 2082- 79- 3) .

**Messmethoden:**

Die angegebenen OH-Zahlen wurden gemäß DIN 53240-2 bestimmt.
Die angegebenen NCO- Werte (Isocyanat- Gehalte) wurden gemäß DIN EN ISO 11909 bestimmt.
Für die Bestimmung der Viskosität wurde die zu untersuchende Komponente oder Mischung bei 20°C in einem Kegel Platte Messsystem eines Rheometers (Firma Anton Paar Physica Modell MCR 51) aufgetragen. Die Messung wird bei folgenden Bedingungen durchgeführt:

- Messkörper: Kegel CP 25, d = 25mm, Winkel = 1°
- Messspalt als Abstand zwischen Kegel und Platte: 0,047 mm
- Messdauer: 10 sec.
- Bestimmung der Viskosität bei einer Scherrate von 250 1/sec.

**Bestimmung des TGA95-Wertes**

Die TGA 95 Werte der einzelnen Komponenten können bestimmt werden, indem eine Menge der Probe der jeweiligen Komponente von ca. 10 mg in ein Aluminiumpfännchen mit einem Volumen von 70 μl eingewogen, das Aluminiumpfännchen einen Ofen einer Thermowaage, bevorzugt einer Thermowaage TG50 der Firma Mettler-Toledo, eingebracht und bei einer konstanten Aufheizrate des Ofens von 20 K/min der Massenverlust der Probe im offenen Aluminiumpfännchen gemessen wird, wobei die Starttemperatur 30 °C und die Endtemperatur 600 °C des Ofens betragen, der Ofen während der Bestimmung mit einem Stickstoffstrom einer Stärke von 200 ml/min durchgespült und als TGA 95 Wert der jeweiligen Komponente die Temperatur ermittelt wird, bei der ein Massenverlust der Probe von 5 Gew.-%, bezogen auf die ursprünglich eingewogene Menge der Probe, eingetreten ist.

**Messung der holographischen Eigenschaften DE und Δn der holographischen Medien mittels Zweistrahlinterferenz in Reflexionsanordnung**

Zur Messung der holographischen Performance wird die Schutzfolie des holographischen Films abgezogen und der holographische Film mit der Photopolymerseite auf eine 1 mm dicke Glasplatte geeigneter Länge und Breite mit einer Gummiwalze unter leichtem Druck auflaminiert. Dieser Sandwich aus Glas und Photopolymerfolie kann nun verwendet werden, um die holographischen Performanceparameter DE und Δn zu bestimmen.
Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die λ/2 Plättchen wurden die Leistung des Referenzstrahls auf 0.5 mW und die Leistung des Signalstrahls

auf 0.65 mW eingestellt. Die Leistungen wurden mit den Halbleiterdetektoren (D) bei ausgebauter Probe bestimmt. Der Einfallswinkel ($\alpha_0$) des Referenzstrahls beträgt -21.8°, der Einfallswinkel ($\beta_0$) des Signalstrahls beträgt 41.8°. Die Winkel werden ausgehend von der Probennormale zur Strahlrichtung gemessen. Gemäß Figur 3 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 225 nm (der Brechungsindex des Mediums zu ~1.504 angenommen),

Figur 3 zeigt den holographischen Versuchsaufbau, mit dem die Beugungseffizienz (DE) der Medien gemessen wurde.

Es wurden auf folgende Weise Hologramme in das Medium geschrieben:

- Beide Shutter (S) sind für die Belichtungszeit t geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also $\alpha_0$ = -31.8° und $\beta_0$ = 31.8° gilt. Dann beträgt $\Omega_{recording}$ = 0°. Für $\alpha_0$ = -21.8° und $\beta_0$ = 41.8° beträgt $\Omega_{recording}$ daher 10°. Allgemein gilt für das Interferenzfeld beim Schreiben ("recording") des Hologramms:

$$\alpha_0 = \theta_0 + \Omega_{recording} .$$

$\theta_0$ ist der Halbwinkel im Laborsystem außerhalb des Mediums und es gilt beim Schreiben des Hologramms:

$$\theta_0 = \frac{\alpha_0 - \beta_0}{2} .$$

In diesem Fall gilt also $\theta_0$ = -31.8°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$ des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die maximale Beugungseffizienz (DE = $\eta_{max}$) des Hologramms, also sein Spitzenwert, wurde bei $\Omega$ reconstruction ermittelt. Eventuell musste dazu die Position des Detektors des abgebeugten Strahls verändert werden, um diesen maximalen Wert zu bestimmen.

Der Brechungsindexkontrast $\Delta n$ und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand Λ' des

Hologramms und die Orientierung der Streifen (slant) vom Streifenabstand A des Interferenzmusters und dessen Orientierung abweichen kann. Demnach wird auch der Winkel $\alpha_0$' bzw. der entsprechende Winkel des Drehtisches $\Omega_{reconstruction}$, bei dem maximale Beugungseffizienz erreicht wird von $\alpha_0$ bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:

Alle geometrischen Größen, die sich auf das geschriebene Hologramm beziehen und nicht auf das Interferenzmuster werden als gestrichene Größen dargestellt.

Für die Braggkurve $\eta(\Omega)$ eines Reflexionshologramms gilt nach Kogelnik:

$$\eta = \begin{cases} \dfrac{1}{1 - \dfrac{1-(\xi/\nu)^2}{\sin^2\left(\sqrt{\xi^2 - \nu^2}\right)}}, \text{ für } \nu^2 - \xi^2 < 0 \\ \dfrac{1}{1 + \dfrac{1-(\xi/\nu)^2}{\sinh^2\left(\sqrt{\nu^2 - \xi^2}\right)}}, \text{ für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left(2 \cdot \cos(\psi' - \vartheta') - \frac{\lambda}{n \cdot \Lambda'}\right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$

$$\sin(\vartheta'_0) = n \cdot \sin(\vartheta')$$

An der Bragg-Bedingung ist das "Dephasing" DP = 0. Und es folgt entsprechend:

$$\alpha'_0 = \theta_0 + \Omega_{reconstruction}$$

$$\sin(\alpha'_0) = n \cdot \sin(\alpha')$$

Der noch unbekannt Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot \left[\sin(\alpha_0) + \sin(\beta_0) - \sin(\theta_0 + \Omega_{reconstruction})\right]$$

v ist die Gitterstärke, ξ ist der Detuning Parameter und ψ' die Orientierung (Slant) des Brechungsindexgitters das geschrieben wurde. α' und β' entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzt. λ ist die Wellenlänge des Laserlichts im Vakuum.

Die maximale Beugungseffizienz (DE = $\eta_{max}$) ergibt sich dann für ξ = 0 zu:

$$DE = \tanh^2(\nu) = \tanh^2\left(\frac{\pi \cdot \Delta n \cdot d'}{\lambda \cdot \sqrt{\cos(\alpha') \cdot \cos(\alpha' - 2\psi)}}\right)$$

Die Messdaten der Beugungseffizienz, die theoretische Braggkurve und die transmittierte Intensität werden wie in Figur 4 gezeigt gegen den zentrierten Drehwinkel $\Delta\Omega \equiv \Omega_{reconstruction} - \Omega = \alpha'_0 - \vartheta'_0$, auch Winkeldetuning genannt, aufgetragen.

Da DE bekannt ist wird die Form der theoretischen Braggkurve nach Kogelnik nur noch durch die Dicke *d'* der Photopolymerschicht bestimmt. Δn wird über DE für gegebene Dicke *d'* so nachkorrigiert, dass Messung und Theorie von DE immer übereinstimmen. *d'* wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für die theoretische Braggkurve und für die transmittierte Intensität übereinstimmen.

Da die Richtung in der ein Reflexionshologramm bei der Rekonstruktion mittels eines Ω-Scans mitrotiert, der Detektor für das abgebeugte Licht aber nur einen endlichen Winkelbereich erfassen kann, wird die Braggkurve von breiten Holgrammen (kleines *d'*) bei einem Ω-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 4 zeigt die Darstellung der Braggkurve η nach der Coupled Wave Theorie (gestrichelte Linie), des gemessenen Beugungswirkungsgrades (ausgefüllte Kreise) und der transmittierten Leistung (schwarz durchgezogene Linie) gegen das Winkeldetuning ΔΩ.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis *E* ergibt sich wie folgt aus den Leistungen der zwei den Winkeln $\alpha_0$ und $\beta_0$ zugeordneten Teilstrahlen (Referenzstrahl mit $P_r$ = 0.50 mW und Signalstrahl mit $P_s$ = 0.63 mW), der Belichtungszeit t und dem Durchmesser der Irisblende (0.4 cm):

$$E\,(\mathrm{mJ/cm^2}) = \frac{2 \cdot [P_r + P_s] \cdot t\,(\mathrm{s})}{\pi \cdot 0.4^2\ \mathrm{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

Als Alternative I wurde auch ein dem in Abbildung 1 dargestellten Aufbau äquivalenter Test mit einem grünen Laser mit der Emissionswellenlänge $\lambda$ im Vakuum von 532 nm durchgeführt. Dabei beträgt $\alpha_0$ = -11.5° und $\beta_0$ = 33.5° und $P_r$ = 1.84 mW und $P_s$ = 2.16 mW.

Als Alternative II wurde auch ein dem in Abbildung 1 dargestellten Aufbau äquivalenter Test mit einem blauen Laser mit der Emissionswellenlänge $\lambda$ im Vakuum von 473 nm durchgeführt. Dabei beträgt $\alpha_0$ = -22.0° und $\beta_0$ = 42.0° und $P_r$ = 1.78 mW und $P_s$ = 2.22 mW.

In Beispielen wird jeweils der maximale Wert in $\Delta n$ berichtet, die verwendeten Dosen liegen zwischen 4 und 64 mJ/cm$^2$ pro Arm.

**Messung der Schichtdicke der Photopolymerschichten**

Die physikalische Schichtdicke wurde mit marktgängigen Weisslichtinterferometern ermittelt, wie z.B. das Gerät FTM-Lite NIR Schichtdickenmessgerät der Firma Ingenieursbüro Fuchs.

Die Bestimmung der Schichtdicke beruht im Prinzip auf Interferenzerscheinungen an dünnen Schichten. Dabei überlagern sich Lichtwellen, die an zwei Grenzflächen unterschiedlicher optischer Dichte reflektiert worden sind. Die ungestörte Überlagerung der reflektierten Teilstrahlen führt nun zur periodischen Aufhellung und Auslöschung im Spektrum eines weißen Kontinuumstrahlers (z.B. Halogenlampe). Diese Überlagerung nennt der Fachmann Interferenz. Diese Interferenzspektren werden gemessen und mathematisch ausgewertet.

**Herstellung der Komponenten:**

Herstellung von Polyol 1 (Komponente b1):

In einem 1 L Kolben wurden 0.18 g Zinnoktoat, 374.8 g $\varepsilon$-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

Herstellung von Polyol 2 (Komponente b2)::

In einen mit Rührwerk ausgestatteten 20 1 - Reaktionskessel wurden 2475 g Terathane® 650 eingewogen und 452,6 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min.wurde für 57 Minuten bei laufender Vakuumpumpe und einem Druck von etwa 0,1 bar von unten Stickstoff durch die Mischung geleitet. Danach wurden mittels Stickstoff ein Druck von 0,5 bar eingestellt und 100 g Ethylenoxid (EO) und 150 g PO parallel zum Start der Polymerisation eingeleitet. Hierbei stieg der Druck auf 2,07 bar. Nach 10 Minuten war der Druck wieder auf 0,68 bar abgefallen und es wurden über einen Zeitraum von 1h 53 min. weitere 5,116 kg EO und 7,558 kg PO als Gemisch bei 2,34 bar zugeleitet. 31 Minuten nach Ende der Epoxiddosierung wurde bei einem Restdruck von 2,16 bar Vakuum angelegt und vollständig entgast. Der Produkt wurde durch Zugabe von 7,5 g Irganox 1076 stabilisiert und als, leicht trübe, viskose Flüssigkeit erhalten (OH-Zahl 27,1 mg KOH/g, Viskosität bei 25 °C: 1636 mPas).

Herstellung, von Polyol 3 (Komponente b3):

In einen mit Rührwerk ausgestatteten 20 1 - Reaktionskessel wurden 2465 g Terathane® 650 eingewogen und 450,5 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min.wurde für 72 Minuten bei laufender Vakuumpumpe und einem Druck von etwa 0,1 bar von unten Stickstoff durch die Mischung geleitet. Danach wurden mittels Stickstoff ein Druck von 0,3 bar eingestellt und 242 g Propylenoxid (PO) zum Start der Polymerisation eingeleitet. Hierbei stieg der Druck auf 2,03 bar. Nach 8 Minuten war der Druck wieder auf 0,5 bar abgefallen und es wurden über einen Zeitraum von 2h 11 min. weitere 12,538 kg PO bei 2,34 bar eindosiert. 17 Minuten nach Ende der PO-Dosierung wurde bei einem Restdruck von 1,29 bar Vakuum angelegt und vollständig entgast. Der Produkt wurde durch Zugabe von 7,5 g Irganox 1076 stabilisiert und als farblose, viskose Flüssigkeit erhalten (OH-Zahl: 27,8 mg KOH/g, Viskosität bei 25 °C: 1165 mPas).

Erstellung des Acrylates 1 (Komponente B1) (Phosphorthioyltris(oxy-4,1-phenyleniminocarbonyloxyethan-2,1-diyl)-triacrylat):

In einem 500 mL Rundkolben wurden 0.1 g 2, 6- Di- tert.- butyl- 4- methylphenol, 0.05 g Dibutylzinn- dilaurat (Desmorapid® Z, Bayer MaterialScience AG, Leverkusen, Deutschland) sowie und 213.07 g einer 27 %- igen Lösung von Tris (p- isocyanatophenyl) thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2- Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

Herstellung des Acrylates 2 (Komponente B2) 2-({[3-(Methylsulfanyl)phenyl]-carbamoyl}oxy)ethylprop-2-enoat):

In einem 100 mL Rundkolben wurden 0.02 g 2, 6- Di- tert.- butyl- 4- methylphenol, 0.01 g Desmorapid® Z, 11.7 g 3- (Methylthio) phenylisocyanat vorgelegt und vorgelegt und auf 60 °C erwärmt. Anschließend wurden 8.2 g 2- Hydroxyethylacrylat zugetropft und die Mischung weiter auf 60 °C gehalten, bis der Isocyanatgehalt unter 0.1 % gesunken war. Danach wurde abgekühlt. Das Produkt wurde als hellgelbe Flüssigkeit erhalten.

Herstellung des Acrylates 3 (Komponenten B3) (Mischung aus (4-Methylbenzol-1,3-diyl)bis[carbamoyloxy-3-(biphenyl-2-yloxy)propan-2,1-diyl]bisacrylat und (4-Methylbenzol-1,3-diyl)bis[carbamoyloxy-3-(biphenyl-2-yloxy)propan-1,2-diyl] bisacrylat und analoger Isomere):

430, 2g Denacol EX 142 (Nagase- Chemtex, Japan), 129, 7g Acrylsäure, 1, 18g Triphenylphosphin und 0, 0056g 2, 6- Di- t.- butyl- 4- methylphenol wurden in einem Dreihalskolben mit Rückflusskühler und Rührwerk vorgelegt. Zudem wurde Luft langsam durchgeleitet und auf 60 °C temperiert. Anschließend wird für 24 Stunden bei 90 °C gerührt. Man erhielt eine klare Flüssigkeit mit OHZ=157, 8 mg KOH/g. 21, 3g dieses Zwischenprodukts und 5, 2g eines Gemischs aus 2, 4 und 2, 6- Toluidendiisocyanat (Desmodur T80, Bayer MaterialScience AG, Leverkusen, Germany) wurden in einem Dreihalskolben mit Rückflusskühler und Rührwerk vorgelegt. Zudem wurde Luft langsam durchgeleitet und auf 60 °C temperiert. Nach anfänglicher Exothermie das Produkt für 24 Stunden bei 60 °C gerührt. Es wurde ein klares, farbloses, gläsernes Produkt mit NCO = 0% erhalten.

Herstellung des Photoinitiatorsystems 1 (Komponente C1)

In einem Becherglas werden im Dunkeln oder unter geeigneter Beleuchtung 0,05 g Farbstoff 1, 0,05 g Farbstoff 2, 0,05 g Farbstoff 4, 1,50 g Coinitiator 1 in 3,50 g N-Ethylpyrolidon gelöst. Von dieser Lösung werden die entsprechenden Gewichtsprozente zur Erstellung der Beispielmedien verwendet.

Herstellung des Photoinitiatorsystems 2 (Komponente C2)

In einem Becherglas werden im Dunkeln oder unter geeigneter Beleuchtung 0,05 g Farbstoff 1, 0,05 g Farbstoff 3, 0,05 g Farbstoff 4, 1,50 g Coinitiator 1 in 3,50 g N-Ethylpyrolidon gelöst. Von dieser Lösung werden die entsprechenden Gewichtsprozente zur Erstellung der Beispielmedien verwendet.

Herstellung des Photoinitiatorsystems 3 (Komponente C3)

In einem Becherglas werden im Dunkeln oder unter geeigneter Beleuchtung 0,10 g Farbstoff 1, 1,00 g Coinitiator 1 in 3,50 g N-Ethylpyrolidon gelöst. Von dieser Lösung werden die entsprechenden Gewichtsprozente zur Erstellung der Beispielmedien verwendet.

Herstellung der nicht photopolymerisierbaren Komponente (Komponente D1) (Bis(2,2,3,3,4,4,5,5,6,6,7,7-dodecafluorheptyl)-(2,2,4-trimethylhexan-1,6-diyl)biscarbamat):

In einem 50 mL Rundkolben wurden 0, 02 g Dibutylzinn- dilaurat (Desmorapid Z, Bayer MaterialScience AG, Leverkusen, Deutschland) und 3, 6 g 2, 4, 4- Trimethylhexane- 1, 6- düsocyanat (TMDI) vorgelegt und auf 60 °C erwärmt. Anschließend wurden 11, 9 g 2, 2, 3, 3, 4, 4, 5, 5, 6, 6, 7, 7- Dodecafluorheptan- 1- ol zugetropft und die Mischung weiter auf 60 °C gehalten, bis der Isocyanatgehalt unter 0, 1 % gesunken war. Danach wurde abgekühlt. Das Produkt wurde

als farbloses Öl erhalten.

Die nachfolgend in Tabelle 2 beschriebenen Additive (Komponente D2 bis D10) wurden auf analoge Art wie für Additiv (Komponente D1) beschrieben in den angegebenen Zusammensetzungen hergestellt.

| Additiv | Name | Isocyanat und Menge | Alkohol und Menge | Katalysator und Menge | Temp [°C] | Beschreibung |
|---|---|---|---|---|---|---|
| **D2** | 2, 2, 3, 3, 4, 4, 5, 5, 6, 6, 7, 7, 8, 8, 9, 9-Hexadecafluornonyl-butylcarbamat | n-Butylisocyanat 186 g | 2, 2, 3, 3, 4, 4, 5, 5, 6, 6, 7, 7, 8, 8, 9, 9-Hexadecafluornonanol 813 g | Desmorapid Z 0,50 g | 60 °C | farblose Flüssigkeit |
| **D3** | 2,2,2-Trifluorethyl-hexylcarbamat | n-Hexylisocyanat 55.9 g | Trifluorethanol 44.0 g | Desmorapid Z 0,05 g | 60 °C | farblose Flüssigkeit |
| **D4** | Bis(1, 1, 1, 3, 3, 3-hexafluorpropan-2-yl)-(2,2,4-trimethylhexan-1,6-diyl)biscarbamat | 2,4,4-Trimethylhexane-1,6-diisocyanat (TMDI) 50.0 g | Hexafluor-2-propanol 80.0 g | Desmorapid Z 0,07 g | 60 °C | farblose Flüssigkeit |
| **D5** | 2, 2, 3, 3, 4, 4, 5, 5, 6, 6, 7, 7- Dodecafluorheptyl-butylcarbamat | n-Butylisocyanat 3,44 g | 2, 2, 3, 3, 4, 4, 5, 5, 6, 6, 7, 7-Dodecafluorheptan-1-ol 11,54 g | Desmorapid Z 0,02 g | 70°C | farblose Flüssigkeit |
| **D6** | 2, 2, 3, 3, 4, 4, 5, 5, 6, 6, 7, 7- Dodecafluorheptyl-hexylcarbamat | n-Hexylisocyanat 4,15 g | 2, 2, 3, 3, 4, 4, 5, 5, 6, 6, 7, 7-Dodecafluorheptan-1-ol 10,84 g | Desmorapid Z 0,02 g | 70°C | farblose Flüssigkeit |
| **D7** | 2, 2, 3, 3, 4, 4, 5, 5, 6, 6, 7, 7- Dodecafluorheptyl-propan-2-ylcarbamat | i-Propylisocyanat 3,06 g | 2, 2, 3, 3, 4, 4, 5, 5, 6, 6, 7, 7-Dodecafluorheptan-1-ol 11,93 g | Desmorapid Z 0,02 g | 70 °C | farblose Flüssigkeit |
| **D8** | 2, 2, 3, 3, 4, 4, 4-Heptaftuorbutyl-hexylcarbamat | n-Hexylisocyanat 5,82 g | 2, 2, 3, 3, 4, 4, 4-Heptafluorbutan-1-ol 9,16 g | Desmorapid Z 0,02 g | 70 °C | farblose Flüssigkeit |
| **D9** | 2, 2, 3, 3, 4, 4, 5, 5, 6, 6, 7, 7, 8, 8, 9, 9-Hexadecafluornonyl-hexylcarbamat | n-Hexylisocyanat 3,40 g | 2, 2, 3, 3, 4, 4, 5, 5, 6, 6, 7, 7, 8, 8, 9, 9-Hexadecafluornonan-1-ol 11,6 g | Desmorapid Z 0,02 g | 70°C | farbloser Feststoff |
| **D10** | 2, 2, 3, 3, 4, 4, 5, 5, 6, 6, 7, 7, 8, 8, 9, 9-Hexadecafluornonyl-cyclohexylcarbamat | Cyclohexylisocyanat 3,37 g | 2, 2, 3, 3, 4, 4, 5, 5, 6, 6, 7, 7, 8, 8, 9, 9-Hexadecafluornonan-1-ol 11,61 g | Desmorapid Z 0,02 g | 70 °C | farbloser Feststoff |

## Herstellung der Proben und Beispielmedien

### Herstellung der Photopolymerformulierung für die Herstellung von holografischen Folien

Tabelle 3 listet die untersuchten Beispiele der Photopolymerformulierungen, die für die kontinuierliche Herstellung von holografischen Folien eingesetzt werden, in ihrer Zusammensetzung auf.

Zur Herstellung der Photopolymerformulierung werden die Komponenten Polyol (Komponente b) schrittweise mit den photopolymerisierbaren Monomeren (Komponente B), mit den nicht polymerisierbaren Komponenten D, dann Fomrez® UL 28 (Komponente E1) und den oberflächenaktiven Additiven BYK 310 (Komponente E2) versetzt und gemischt. Anschließend wird eine Lösung der Komponente C der Photopolymerlösung im Dunklen hinzugefügt und vermischt, so dass eine klare Lösung erhalten wurde. Gegebenenfalls kann die Formulierung für kurze Zeit bei 60°C erwärmt werden, um die Löslichkeit der Einsatzstoffe zu unterstützen. Zuletzt wird bei 30°C die entsprechende Isocyanat Komponente a zugegeben und erneut gemischt. Die erhaltene, flüssige Masse wird dann mittels Rakel oder Schlitzdüse auf eine 36 μm dicke Polyethylenterephthalatfolie appliziert, und für 4,5 Minuten bei der entsprechenden Trocknungstemperatur (siehe Beispieltabelle 6) in einem Umlufttrockner getrocknet. Anschließend wird die Photopolymerschicht mit einer 40 μm dicken Polyethylenfolie abgedeckt und aufgewickelt.

Die gewünschte Zielschichtdicke der getrockneten Photopolymere liegen vorzugsweise zwischen 10 bis 20 μm. Die erzielten Schichtdicken für die hergestellten holografischen Folien sind der Tabelle 6 zu entnehmen.

Die Herstellgeschwindigkeiten liegen bevorzugt im Bereich von 0,2 m/min bis 300 m/min und besonders bevorzugt im Bereich vom 1,0 m/min bis 50 m/min.

Diese Art der holographischen Filme ist besonders geeignet, um deren Performance nach der im Abschnitt Messung der holographischen Eigenschaften DE und Δn der holographischen Medien mittels Zweistrahlinterferenz in Reflektionsanordnung beschriebenen Verfahren zu bestimmen.

| holographisches Medium | Isocyanat Komponente | Anteil (Gew. %) | isocyanatreaktive Komponente | Anteil (Gew. %) | NCO : OH | Photopolymerisierbares Monomer 1 | Anteil (Gew. %) | Photopolymerisierbares Monomer 2 | Anteil (Gew. %) | Nicht photopolymerisierbare Komponente | Anteil (Gew. %) | Photinitiator | Anteil (Gew. %) | Hilfs- und Zusatzstoffe | Anteil (Gew. %) | Katalysator in Lösung | Anteil (Gew. %) |
|---|---|---|---|---|---|---|---|---|---|---|---|---|---|---|---|---|---|
| M1 | a1 | 6,30 | b1 | 33,80 | 1.02 : 1 | B1 | 20,0 | B2 | 20,0 | D3 | 15,0 | C3 | 4,59 | E2 | 0,30 | E1 | 0,010 |
| M2 | a1 | 6,30 | b1 | 33,80 | 1.02 : 1 | B1 | 20,0 | B2 | 20,0 | D7 | 15,0 | C3 | 4,59 | E2 | 0,30 | E1 | 0,010 |
| M3 | a1 | 6,30 | b1 | 33,80 | 1.02 : 1 | B1 | 20,0 | B2 | 20,0 | D8 | 15,0 | C3 | 4,59 | E2 | 0,30 | E1 | 0,010 |
| M4 | a1 | 6,30 | b1 | 33,80 | 1.02 : 1 | B1 | 20,0 | B2 | 20,0 | D2 | 15,0 | C3 | 4,59 | E2 | 0,30 | E1 | 0,010 |
| M5 | a1 | 6,16 | b1 | 33,23 | 1.02 : 1 | B1 | 15,0 | B2 | 15,0 | D2 | 25,0 | C1 | 5,30 | E2 | 0,30 | E1 | 0,010 |
| M6 | a1 | 6,16 | b1 | 33,23 | 1.02 : 1 | B1 | 15,0 | B2 | 15,0 | D1 | 25,0 | C1 | 5,30 | E2 | 0,30 | E1 | 0,010 |
| M7 | a1 | 6,30 | b1 | 33,80 | 1.02 : 1 | B1 | 20,0 | B2 | 20,0 | D2 | 15,0 | C3 | 4,59 | E2 | 0,30 | E1 | 0,010 |
| M8 | a1 | 6,30 | b1 | 33,80 | 1.02 : 1 | B1 | 20,0 | B2 | 20,0 | D6 | 15,0 | C3 | 4,59 | E2 | 0,30 | E1 | 0,010 |
| M9 | a1 | 6,30 | b1 | 33,80 | 1.02 : 1 | B1 | 20,0 | B2 | 20,0 | D10 | 15,0 | C3 | 4,59 | E2 | 0,30 | E1 | 0,010 |
| M10 | a2 | 4,52 | b3 | 34,93 | 1.02 : 1 | B1 | 15,0 | B2 | 15,0 | D1 | 25,0 | C1 | 5,15 | E2 | 0,30 | E1 | 0,100 |
| M11 | a3 | 6,93 | b2 | 32,27 | 1.02 : 1 | B1 | 15,0 | B2 | 15,0 | D1 | 25,0 | C2 | 5,40 | E2 | 0,30 | E1 | 0,100 |
| M12 | a1 | 6,30 | b1 | 33,80 | 1.02 : 1 | B1 | 20,0 | B2 | 20,0 | D1 | 15,0 | C3 | 4,59 | E2 | 0,30 | E1 | 0,010 |
| M13 | a2 | 4,40 | b2 | 34,85 | 1.02 : 1 | B1 | 15,0 | B2 | 15,0 | D9 | 25,0 | C2 | 5,40 | E2 | 0,30 | E1 | 0,050 |
| M14 | a2 | 4,40 | b2 | 34,85 | 1.02 : 1 | B1 | 15,0 | B2 | 15,0 | D4 | 25,0 | C2 | 5,40 | E2 | 0,30 | E1 | 0,050 |
| M15 | a2 | 4,40 | b2 | 34,85 | 1.02 : 1 | B1 | 15,0 | B2 | 15,0 | D5 | 25,0 | C2 | 5,40 | E2 | 0,30 | E1 | 0,050 |
| M16 | a1 | 6,16 | b1 | 33,23 | 1.02 : 1 | B3 | 15,0 | B2 | 15,0 | D1 | 25,0 | C1 | 5,30 | E2 | 0,30 | E1 | 0,010 |

Tabelle 3: Holographische Medien die auf ihre Performance Δn geprüft wurden

**Herstellung von holografischen Medien im Glasaufbau**

Zur Herstellung der holografischen Medien werden die Schreibmonomere (Komponente B), die Stabilisatoren (Komponente E) (die bereits in der Komponente C vorgelöst sein kann) sowie gegebenenfalls die Hilfs- und Zusatzstoffe (Komponente E) in der isocyanat-reaktiven Komponente (Komponente b) gegebenenfalls bei 60 °C gelöst, dann werden Glasperlen der Größe 10 oder 20 μm (z. B. der Fa. Whitehouse Scientific Ltd, Waverton, Chester, CH3 7PB, United Kingdom) zugegeben und gründlich gemischt. Danach wird im Dunklen oder unter geeigneter Beleuchtung der oder die Photoinitiatoren (zusammen Komponente C) in reiner Form oder in verdünnter Lösung in N-Ethylpyrrolidon (Teil der Komponente C) zugewogen und erneut 1 Minute gemischt. Gegebenenfalls wird maximal 10 Minuten im Trockenschrank auf 60 °C erhitzt. Dann wird die Isocyanatkomponente (Komponente a) zugegeben und wieder im 1 Minute gemischt. Im Folgenden wird eine Lösung des Katalysators (Komponente E1) zugegeben und im erneut 1 Minute gemischt. Die erhaltene Mischung wird unter Rühren bei < 1 mbar maximal 30 Sekunden entgast, dann wird sie auf Glasplatten von 50 x 75 mm verteilt und diese je mit einer weiteren Glasplatte abgedeckt. Die Härtung der PU-Formulierung erfolgt unter 15 kg Gewichten über mehrere Stunden (gewöhnlich über Nacht). Teilweise werden die Medien in lichtdichter Verpackung noch 2 Stunden bei 60 °C nachgehärtet. Die Dicke d der Photopolymerschicht ergibt sich aus dem Durchmesser der verwendeten Glaskugeln zu 20 μm. Da unterschiedliche Formulierungen mit unterschiedlicher Ausgangsviskosität und unterschiedlicher Härtungsgeschwindigkeit der Matrix zu nicht immer gleichen Schichtdicken d der Photopolymerschicht führen, wird d anhand der Charakteristika der geschriebenen Hologramme für jede Probe separat ermittelt. Analog zu dieser Vorschrift wurden die Medien der im Labor hergestellten Vergleichsmedien (siehe Tabelle 4) hergestellt.

**Folgende TGA 95:** Messwerte wurden für die Schreibmonomere B) nach der Formel IV beschriebenen nicht photopolymerisierbaren Komponenten D) ermittelt :

| Komponente | Bezeichnung | TGA 95 in °C |
|---|---|---|
| B1 | Phosphorthioyltris(oxy-4,1-phenyleniminocarbonyloxyethan-2,1-diyl)-triacrylat | 177,2 |
| B2 | 2-({[3-(Methylsulfanyl)phenyl]carbamoyl}oxy)ethylprop-2-enoat | 190,3 |
| B3 | Mischung aus (4-Methylbenzol-1,3-diyl)bis[carbamoyloxy-3-(biphenyl-2-yloxy)propan-2,1-diyl]bisacrylat und (4-Methylbenzol-1,3-diyl)bis[carbamoyloxy-3-(biphenyl-2-yloxy)propan-1,2-diyl]bisacrylat und analoger Isomere | 239,5 |
| D1 | Bis(2,2,3,3,4,4,5,5,6,6,7,7-dodecafluorheptyl)-(2,2,4-trimethylhexan-1,6-diyl)biscarbamat | 189,5 |
| D2 | 2,2,3,3,4,4,5,5,6,6,7,7,8,8,9,9-Hexadecafluornonyl-butylcarbamat | 111,8 |
| D3 | 2,2,2-Trifluorethyl-hexylcarbamat | 72,5 |
| D4 | Bis(1,1,1,3,3,3-hexafluorpropan-2-yl)-(2,2,4-trimethylhexan-1,6-diyl)biscarbamat | 139,1 |
| D5 | 2,2,3,3,4,4,5,5,6,6,7,7-Dodecafluorheptyl-butylcarbamat | 112,6 |
| D6 | 2,2,3,3,4,4,5,5,6,6,7,7-Dodecafluorheptyl-hexylcarbamat | 117,6 |
| D7 | 2,2,3,3,4,4,5,5,6,6,7,7-Dodecafluorheptyl-propan-2-ylcarbamat | 93,3 |
| D8 | 2,2,3,3,4,4,4-Heptafluorbutyl-hexylcarbamat | 82,3 |
| D9 | 2,2,3,3,4,4,5,5,6,6,7,7,8,8,9,9-Hexadecafluornonyl-hexylcarbamat | 125,9 |
| D10 | 2,2,3,3,4,4,5,5,6,6,7,7,8,8,9,9-Hexadecafluornonyl-cyclohexylcarbamat | 130,8 |

Tabelle 4: Auflistung der Komponenten B und D die auf TGA 95 geprüft wurden

**Ergebnisse der holografischen Eigenschaft Δn**

Folgende Messwerte der in Tabelle 3 beschriebenen holografischen Medien sind in Tabelle 5 dargestellt:

| holographisches Medium | Beispiel Typ | Trocknung (Zeit min / Temperatur °C) | Trockenschichtdicke (µm) | Δn (633nm) | E (mJ/cm²) | Δn (532nm) | E (mJ/cm²) |
|---|---|---|---|---|---|---|---|
| M1 | Vergleichsbeispiel 1 | 4,5 / 80 | 12 - 14 | 0.012 | 9 - 36 | | |
| M2 | Vergleichsbeispiel 2 | 4,5 / 80 | 15 - 17 | 0.011 | 9 - 36 | | |
| M3 | Vergleichsbeispiel 3 | 4,5 / 80 | 15 - 16 | 0.011 | 9 - 36 | | |
| M4 | Vergleichsbeispiel 4 | 4,5 / 100 | 16 - 18 | 0.010 | 9 - 36 | | |
| M5 | Beispiel 1 | 4,5 / 80 | 12 - 14 | 0.037 | 9 - 36 | 0.034 | 16 - 128 |
| M6 | Beispiel 2 | 4,5 / 80 | 15 - 16 | 0.034 | 9 - 36 | 0.032 | 16 - 128 |
| M7 | Beispiel 3 | 4,5 / 80 | 15 - 16 | 0.038 | 9 - 36 | | |
| M8 | Beispiel 4 | 4,5 / 80 | 16 - 17 | 0.027 | 9 - 36 | | |
| M9 | Beispiel 5 | 4,5 / 80 | 16 - 17 | 0.029 | 9 - 36 | | |
| M10 | Beispiel 6 | 4,5 / 80 | 11 - 12 | | | 0.031 | 16 - 128 |
| M11 | Beispiel 7 | 4,5 / 80 | 15 - 17 | 0.036 | 9 - 36 | | |
| M12 | Beispiel 8 | 4,5 / 80 | 11 - 13 | 0.031 | 9 - 36 | | |
| M13 | Beispiel 9 | 4,5 / 80 | 15 - 17 | 0.037 | 9 - 36 | 0.035 | 16 - 128 |
| M14 | Beispiel 10 | 4,5 / 80 | 15 - 17 | 0.028 | 9 - 36 | 0.033 | 16 - 128 |
| M15 | Beispiel 11 | 4,5 / 80 | 15 - 17 | 0.029 | 9 - 36 | 0.030 | 16 - 128 |
| M16 | Beispiel 12 | 4,5 / 80 | 12 - 13 | 0.037 | 9 - 36 | 0.033 | 16 - 128 |

Tabelle 5: **Holografische Messergebnisse Δn in Abhängigkeit diverser Zusammensetzungen und Trocknungsbedingungen.**

Die Auswahl geeigneter Photopolymerformulierungen wird zum Einen durch eine Gegenüberstellung der gemessenen Δn Werte im Folienaufbau vorgenommen. Hierbei überzeugen die Beispiele M5 bis M16.

Tabelle 6 zeigt den direkten Vergleich der im Labor hergestellten Medien zu den offen gehärteten Photopolymerformulierungen

| holographisches Medium | Beispiel Typ | Trocknung (Zeit min / Temperatur °C) | Trockenschichtdicke (µm) | Δn (633nm) Folienaufbau | E (mJ/cm²) | Δn (633nm) Labor Medium | E (mJ/cm²) |
|---|---|---|---|---|---|---|---|
| M1 | Vergleichsbeispiel 1 | 4,5 / 80 | 12 - 14 | 0.012 | 9 - 36 | 0.024 | 9 - 36 |
| M2 | Vergleichsbeispiel 2 | 4,5 / 80 | 15 - 17 | 0.011 | 9 - 36 | 0.035 | 9 - 36 |
| M3 | Vergleichsbeispiel 3 | 4,5 / 80 | 15 - 16 | 0.011 | 9 - 36 | 0.033 | 9 - 36 |
| M4 | Vergleichsbeispiel 4 | 4,5 / 100 | 16 - 18 | 0.010 | 9 - 36 | 0.039 | 9 - 36 |
| M5 | Beispiel 1 | 4,5 / 80 | 12 - 14 | 0.037 | 9 - 36 | 0.039 | 9 - 36 |
| M7 | Beispiel 3 | 4,5 / 80 | 15 - 16 | 0.038 | 9 - 36 | 0.039 | 9 - 36 |
| M8 | Beispiel 4 | 4,5 / 80 | 16 - 17 | 0.027 | 9 - 36 | 0.025 | 9 - 36 |
| M9 | Beispiel 5 | 4,5 / 80 | 16 - 17 | 0.029 | 9 - 36 | 0.030 | 9 - 36 |
| M12 | Beispiel 8 | 4,5 / 80 | 11 - 13 | 0.031 | 9 - 36 | 0.037 | 9 - 36 |

Tabelle 6: Vergleich der Holografische Messergebnisse Δn des Photopolymers im Folienaufbau gegen Photopolymer, die im Labor hergestellt wurden

Der Vergleich aus der Tabelle 6 zeigt, dass die holografische Eigenschaft Δn im Folienaufbau der Versuche M1 bis M4 nicht mit den Ergebnissen aus dem im Labor hergestellten Photopolymeren übereinstimmen. Die Beispiele M5 - M12 zeigen hingegen nahezu vergleichbare holografische Eigenschaften

Somit können die Photopolymerformulierungen der Beispiel M5 bis M16 als geeignete Formulierungen für die großtechnische Herstellung von holographischen Filmen mit sehr guten holografischen Eigenschaften identifiziert werden.

## Patentansprüche

**1.** Verfahren zur Herstellung von holographischen Medien, bei dem

i) eine Photopolymer-Formulierung umfassend als Komponenten

A) Matrixpolymere
B) Schreibmonomere
C) Photoinitiatorsystem

D) optional eine nicht photopolymerisierbare Komponente
E) und gegebenenfalls Katalysatoren, Radikalstabilisatoren, Lösungsmittel, Additive sowie andere Hilfs- und / oder Zusatzstoffe

bereit gestellt,
ii) die Photopolymer-Formulierung flächig als Schicht auf eine Trägerfolie aufgebracht und
iii) die Photopolymer-Formulierung auf der Trägerfolie bei einer Temperatur 60 < T > 120 °C getrocknet wird,

**dadurch gekennzeichnet, dass** als Komponenten für die Photopolymer-Formulierung nur Verbindungen ausgewählt werden, deren TGA 95 Werte > 100°C sind und mindestens 30 °C über der Temperatur T liegen.

**2.** Verfahren nach Anspruch 1, **dadurch gekennzeichnet, dass** die TGA 95 Werte der einzelnen Komponenten bestimmt werden, indem eine Menge der Probe der jeweiligen Komponente von ca. 10 mg in ein Aluminiumpfännchen mit einem Volumen von 70 $\mu$l eingewogen, das Aluminiumpfännchen einen Ofen einer Thermowaage, bevorzugt einer Thermowaage TG50 der Firma Mettler-Toledo, eingebracht und bei einer konstanten Aufheizrate des Ofens von 20 K/min der Massenverlust der Probe im offenen Aluminiumpfännchen gemessen wird, wobei die Starttemperatur 30 °C und die Endtemperatur 600 °C des Ofens betragen, der Ofen während der Bestimmung mit einem Stickstoffstrom einer Stärke von 200 ml/min durchgespült und als TGA 95 Wert der jeweiligen Komponente die Temperatur ermittelt wird, bei der ein Massenverlust der Probe von 5 Gew.-%, bezogen auf die ursprünglich eingewogene Menge der Probe, eingetreten ist.

**3.** Verfahren nach einem der Ansprüche 1 oder 2, **dadurch gekennzeichnet, dass** die Photopolymer-Formulierung bei einer Temperatur 70 < T < 100 °C getrocknet wird.

**4.** Verfahren nach einem der Ansprüche 1 bis 3, **dadurch gekennzeichnet, dass** die Matrixpolymere Polyurethane sind.

**5.** Verfahren nach Anspruch 4, **dadurch gekennzeichnet, dass** die Polyurethane erhältlich sind durch Umsetzung von einer Isocyanatkomponente a) und einer Isocyanat-reaktiven Komponente b).

**6.** Verfahren nach einem der Ansprüche 1 bis 5, **dadurch gekennzeichnet, dass** die Schreibmonomere Acrylate und / oder Methacrylate sind.

**7.** Verfahren nach einem der Ansprüche 1 bis 6, **dadurch gekennzeichnet, dass** als Schreibmonomere eine Kombination aus einem monofunktionellen und einem multifunktionellen Schreibmonomer verwendet wird.

**8.** Verfahren nach Anspruch 7, **dadurch gekennzeichnet, dass** das monofunktionelle Schreibmonomer die allgemeine Formel (II)

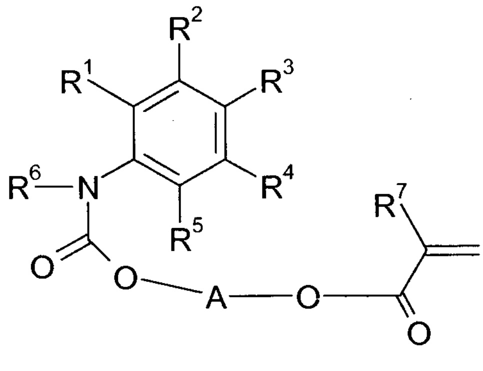

(II)

hat, in der $R^1$, $R^2$, $R^3$, $R^4$, $R^5$ jeweils unabhängig voneinander ein Wasserstoff oder Halogenatom oder eine C1- C6- Alkyl-, Trifluormethyl-, C1- C6- Alkylthio-, C1- C6- Alkylseleno-, C1- C6- Alkyltelluro- oder Nitro- Gruppe sind, mit der Maßgabe dass wenigstens ein Substituent der Gruppe $R^1$, $R^2$, $R^3$, $R^4$, $R^5$ nicht Wasserstoff ist, $R^6$, $R^7$ jeweils für sich Wasserstoff oder eine C1- C6- Alkylgruppe sind und A ein gesättigter oder ungesättigter oder linearer oder verzweigter C1- C6- Alkyl- Rest oder ein Polyethylenoxid- Rest oder ein Polypropylenoxid- Rest mit jeweils 2-6 Widerholungseinheiten in der Polymerkette ist, und das monofunktionelle Schreibmonomer bevorzugt eine Glastemperatur $T_G$ < 0°C und bevorzugt einen Brechungsindex> 1.50 bei 405 nm aufweist.

**9.** Verfahren nach einem der Ansprüche 7 oder 8, **dadurch gekennzeichnet, dass** das multifunktionelle Schreibmonomer die allgemeine Formel (III)

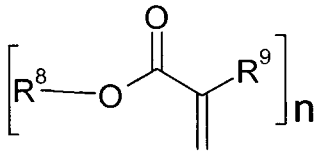

(III)

hat, in der n≥2 und n≤4 ist und $R^8$, $R^9$ Wasserstoff und / oder unabhängig voneinander lineare, verzweigte, cyclische oder heterocyclische unsubstituierte oder gegebenenfalls auch mit Heteroatomen substituierte organische Reste sind und das multifunktionelle Schreibmonomer bevorzugt einen Brechungsindex >1.50 bei 405 nm aufweist.

**10.** Verfahren nach einem der Ansprüche 1 bis 9, **dadurch gekennzeichnet, dass** die Photopolymer-Formulierung als Weichmacher Urethane enthält, wobei die Urethane bevorzugt mit wenigstens einem Fluoratom substituiert sind.

**11.** Verfahren nach Anspruch 10, **dadurch gekennzeichnet, dass** als Weichmacher Urethane der allgemeinen Formel (IV)

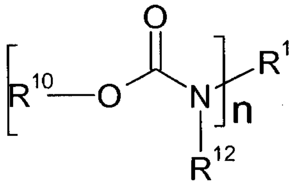

(IV)

verwendet werden, bei denen n≥1 und n≤8 ist und $R^{10}$, $R^{11}$, $R^{12}$ Wasserstoff und / oder unabhängig voneinander lineare, verzweigte, cyclische oder heterocyclische unsubstituierte oder gegebenenfalls auch mit Heteroatomen substituierte organische Reste sind, wobei bevorzugt mindestens einer der Reste $R^{10}$, $R^{11}$, $R^{12}$ mit wenigstens einem Fluoratom substituiert ist und besonders bevorzugt $R^{10}$ ein organischer Rest mit mindestens einem Fluoratom ist.

**12.** Verfahren nach einem der Ansprüche 1 bis 11 **dadurch gekennzeichnet, dass** das Photoinitiatorsystem einen anionischen, kationischen oder neutralen Farbstoff und einen Coinitiator umfasst.

**13.** Verfahren nach einem der Ansprüche 1 bis 12, **dadurch gekennzeichnet, dass** die Photopolymer-Formulierung als Film auf eine Trägerfolie aufgebracht und der Film mit einer Schutzfolie abgedeckt wird.

**14.** Holographisches Medium, erhältlich nach einem Verfahren gemäß einem der Ansprüche 1 bis 13.

## Claims

**1.** Process for producing holographic media in which

(i) a photopolymer formulation comprising, as components,

A) matrix polymers
B) writing monomers
C) photoinitiator system
D) optionally a non-photopolymerizable component
E) and optionally catalysts, free radical stabilizers, solvents, additives and other auxiliaries and/or additives

is provided,
ii) the photopolymer formulation is applied extensively as a layer to a substrate film and
iii) the photopolymer formulation is dried on the substrate film at a temperature of 60 < T > 120°C,

**characterized in that** only compounds whose TGA 95 values are > 100°C and are at least 30°C above the temperature T are chosen as components for the photopolymer formulation.

2. Process according to Claim 1, **characterized in that** the TGA 95 values of the individual components are determined by weighing an amount of about 10 mg of the sample of the respective component into a small aluminium pan having a volume of 70 μl, introducing the small aluminium pan an oven of a thermobalance, preferably a TG50 thermobalance from Mettler-Toledo, and measuring the loss of mass of the sample in the open small aluminium pan at a constant oven heating rate of 20 K/min, the start temperature of the oven being 30°C and the end temperature 600°C, the oven being flushed with a 200 ml/min nitrogen stream during the determination and the temperature at which a loss of mass of the sample of 5% by weight, based on the originally weighed in amount of the sample, has occurred being determined as the TGA 95 value of the respective component.

3. Process according to either of Claims 1 and 2, **characterized in that** the photopolymer formulation is dried at a temperature 70 < T < 100°C.

4. Process according to any of Claims 1 to 3, **characterized in that** the matrix polymers are polyurethanes.

5. Process according to Claim 4, **characterized in that** the polyurethanes are obtainable by reacting an isocyanate component a) and an isocyanate-reactive component b).

6. Process according to any of Claims 1 to 5, **characterized in that** the writing monomers are acrylates and/or methacrylates.

7. Process according to any of Claims 1 to 6, **characterized in that** a combination of a monofunctional and a polyfunctional writing monomer is used as writing monomers.

8. Process according to Claim 7, **characterized in that** the monofunctional writing monomer has the general formula (II)

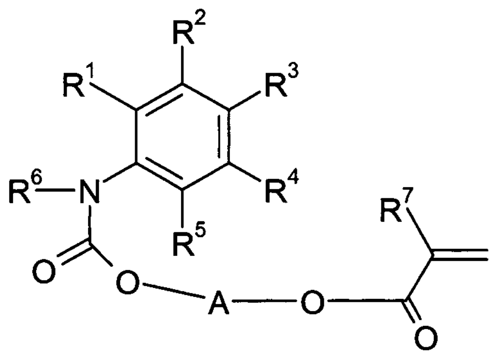

(II)

in which R1, R2, R3, R4, R5, in each case independently of one another, are a hydrogen or halogen atom or a C1- C6- alkyl, trifluoromethyl, C1- C6- alkylthio, C1- C6- alkylseleno, C1- C6- alkyltelluro or nitro group, with the proviso that at least one substituent of the group R1, R2, R3, R4, R5 is not hydrogen, R6, R7, in each case by themselves, are hydrogen or a Cl- C6- alkyl group and A is a saturated or unsaturated or linear or branched C1- C6- alkyl radical or a polyethylene oxide radical or a polypropylene oxide radical having in each case 2- 6 repeating units in the polymer chain, and the monofunctional writing monomer preferably has a glass transition temperature $T_G$ of < 0°C and preferably a refractive index of > 1.50 at 405 nm.

9. Process according to either of Claims 7 and 8, **characterized in that** the polyfunctional writing monomer has the general formula (III)

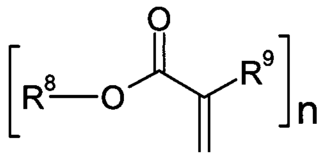

(III)

in which n is ≥2 and n is ≤4 and $R^8$, $R^9$ are hydrogen and/or, independently of one another, linear, branched, cyclic or heterocyclic organic radicals which are unsubstituted or optionally also substituted by heteroatoms and the polyfunctional writing monomer preferably has a refractive index of > 1.50 at 405 nm.

**10.** Process according to any of Claims 1 to 9, **characterized in that** the photopolymer formulation contains, as a plasticizer, urethanes, the urethanes preferably being substituted by at least one fluorine atom.

**11.** Process according to Claim 10, **characterized in that**, as plasticizers, urethanes of the general formula (IV)

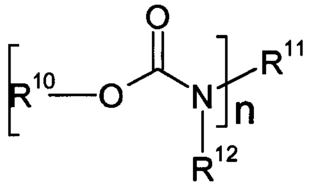

(IV)

are preferably used, in which n is ≥1 and n is ≤8 and $R^{10}$, $R^{11}$, $R^{12}$ are hydrogen and/or, independently of one another, linear, branched, cyclic or heterocyclic organic radicals which are unsubstituted or optionally also substituted by heteroatoms, preferably at least one of the radicals $R^{10}$, $R^{11}$, $R^{12}$ being substituted by at least one fluorine atom and particularly preferably $R^{10}$ being an organic radical having at least one fluorine atom.

**12.** Process according to any of Claims 1 to 11, **characterized in that** the photoinitiator system comprises an anionic, cationic or neutral dye and a coinitiator.

**13.** Process according to any of Claims 1 to 12, **characterized in that** the photopolymer formulation is applied as a film to a substrate film and the film is covered by a protective film.

**14.** Holographic medium obtainable by a process according to any of Claims 1 to 13.

## Revendications

**1.** Procédé de fabrication d'agents holographiques, dans lequel

i) une formulation de photopolymère, comprenant comme composants

A) des polymères de matrice
B) des monomères d'enregistrement
C) un système photo-initiateur
D) éventuellement un composant non photopolymérisable
E) et le cas échéant des catalyseurs, des stabilisateurs de radicaux, des solvants, des additifs ainsi que d'autres adjuvants et/ou substances auxiliaires

est mise à disposition,
ii) la formulation de photopolymère est appliquée à plat sous forme de couche sur une feuille support et
iii) la formulation de photopolymère est séchée sur la feuille support à une température 60 < T > 120°C,

**caractérisé en ce qu'**on choisit, comme composants pour la formulation de photopolymère, uniquement des composés dont les valeurs TGA 95 > 100°C et se situent au moins 30°C au-dessus de la température T.

**2.** Procédé selon la revendication 1, **caractérisé en ce que** les valeurs TGA 95 des différents composants sont déterminées **en ce qu'**une quantité d'échantillon de chaque composant d'environ 10 mg est pesée dans une coupelle en aluminium d'un volume de 70 $\mu$l, la coupelle en aluminium est introduite dans un four d'une thermobalance, de préférence une thermobalance TG50 de la société Mettler-Toledo, et on mesure, à une vitesse de chauffage constante du four de 20 K/min, la perte de masse de l'échantillon dans la coupelle en aluminium ouverte, la température de départ du four étant de 30°C et la température finale du four de 600°C, le four étant rincé, pendant la détermination, par un flux d'azote d'un débit de 200 ml/min et en déterminant comme valeur TGA 95 de chaque composant la température à laquelle une perte de masse de l'échantillon de 5% en poids par rapport à la quantité d'échantillon pesée au départ, est atteinte.

**3.** Procédé selon l'une quelconque des revendications 1 ou 2, **caractérisé en ce que** la formulation de photopolymère est séchée à une température $70 < T < 100$°C.

**4.** Procédé selon l'une quelconque des revendications 1 à 3, **caractérisé en ce que** les polymères de matrice sont des polyuréthanes.

**5.** Procédé selon la revendication 4, **caractérisé en ce que** les polyuréthanes peuvent être obtenus par transformation d'un composant isocyanate a) et d'un composant b) réactif avec isocyanate.

**6.** Procédé selon l'une quelconque des revendications 1 à 5, **caractérisé en ce que** les monomères d'enregistrement sont des acrylates et/ou des méthacrylates.

**7.** Procédé selon l'une quelconque des revendications 1 à 6, **caractérisé en ce qu'**on utilise, comme monomères d'enregistrement, une combinaison d'un monomère d'enregistrement monofonctionnel et d'un monomère d'enregistrement polyfonctionnel.

**8.** Procédé selon la revendication 7, **caractérisé en ce que** le monomère d'enregistrement monofonctionnel présente la formule générale (II)

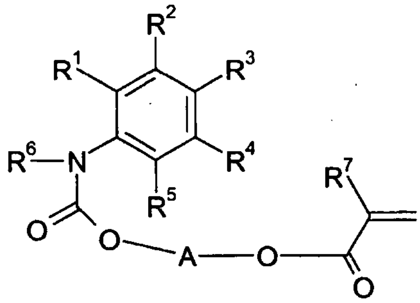

(II)

dans laquelle $R^1$, $R^2$, $R^3$, $R^4$, $R^5$ représentent, à chaque fois indépendamment les uns des autres, un atome d'hydrogène ou d'halogène ou un groupe $C_1$- $C_6$- alkyle, trifluorométhyle, $C_1$- $C_6$- alkylthio, $C_1$- $C_6$- alkylséléno, $C_1$- $C_6$-alkyltelluro ou nitro, à condition qu'au moins un substituant du groupe $R^1$, $R^2$, $R^3$, $R^4$, $R^5$ ne représente pas hydrogène, $R^6$, $R^7$ représentent à chaque fois en soi hydrogène ou un groupe $C_1$- $C_6$- alkyle et A représente un radical $C_1$- $C_6$-alkyle saturé ou insaturé ou linéaire ou ramifié ou un radical poly (oxyde d'éthylène) ou un radical poly (oxyde de propylène) comprenant à chaque fois 2- 6 unités récurrentes dans la chaîne polymère et le monomère d'enregistrement monofonctionnel présente de préférence une température de transition vitreuse $T_G < 0$°C et de préférence un indice de réfraction > 1, 50 à 405 nm.

**9.** Procédé selon l'une quelconque des revendications 7 ou 8, **caractérisé en ce que** le monomère d'enregistrement multifonctionnel présente la formule générale (III)

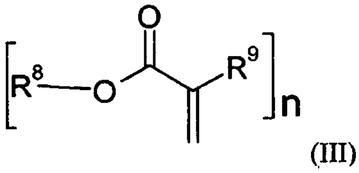

(III)

dans laquelle n ≥ 2 et n ≤ 4 et $R^8$, $R^9$ représentent hydrogène et/ou, indépendamment l'un de l'autre, des radicaux organiques linéaires, ramifiés, cycliques ou hétérocycliques, non substitués ou le cas échéant également substitués par des hétéroatomes et le monomère d'enregistrement multifonctionnel présente de préférence un indice de réfraction > 1,50 à 405 nm.

**10.** Procédé selon l'une quelconque des revendications 1 à 9, **caractérisé en ce que** la formulation de photopolymère contient, comme plastifiant, des uréthanes, les uréthanes étant de préférence substitués par au moins un atome de fluor.

**11.** Procédé selon la revendication 10, **caractérisé en ce qu'**on utilise, comme plastifiant, des uréthanes de formule générale (IV)

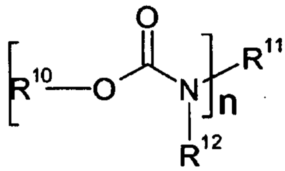

(IV)

dans laquelle n ≥ 1 et n ≤ 8 et $R^{10}$, $R^{11}$, $R^{12}$ représentent hydrogène et/ou, indépendamment l'un de l'autre, des radicaux organiques linéaires, ramifiés, cycliques ou hétérocycliques, non substitués ou le cas échéant également substitués par des hétéroatomes, de préférence au moins un des radicaux $R^{10}$, $R^{11}$, $R^{12}$ étant substitué par au moins un atome de fluor et $R^{10}$ représentant de manière particulièrement préférée un radical organique comprenant au moins un atome de fluor.

**12.** Procédé selon l'une quelconque des revendications 1 à 11, **caractérisé en ce que** le système de photo-initiateur comprend un colorant anionique, cationique ou neutre et un co-initiateur.

**13.** Procédé selon l'une quelconque des revendications 1 à 12, **caractérisé en ce que** la formulation de photopolymère est appliquée sous forme de film sur une feuille support et le film est revêtu par une feuille de protection.

**14.** Agent holographique, pouvant être obtenu selon un procédé selon l'une quelconque des revendications 1 à 13.

**Figur 1:**

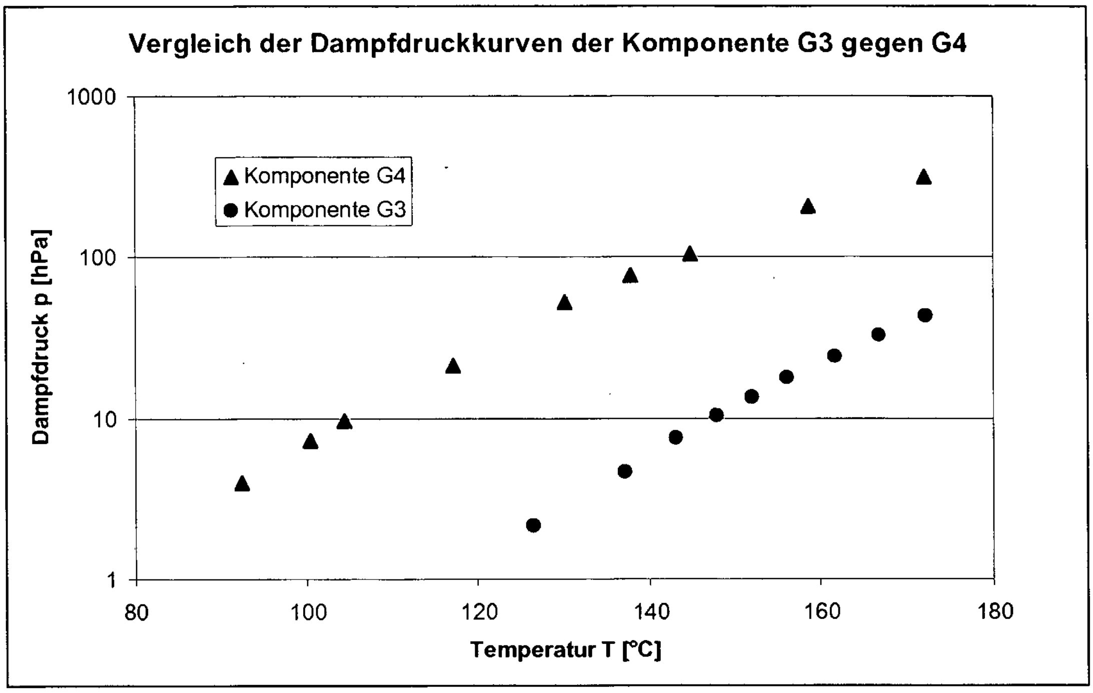


**Figur 2:**

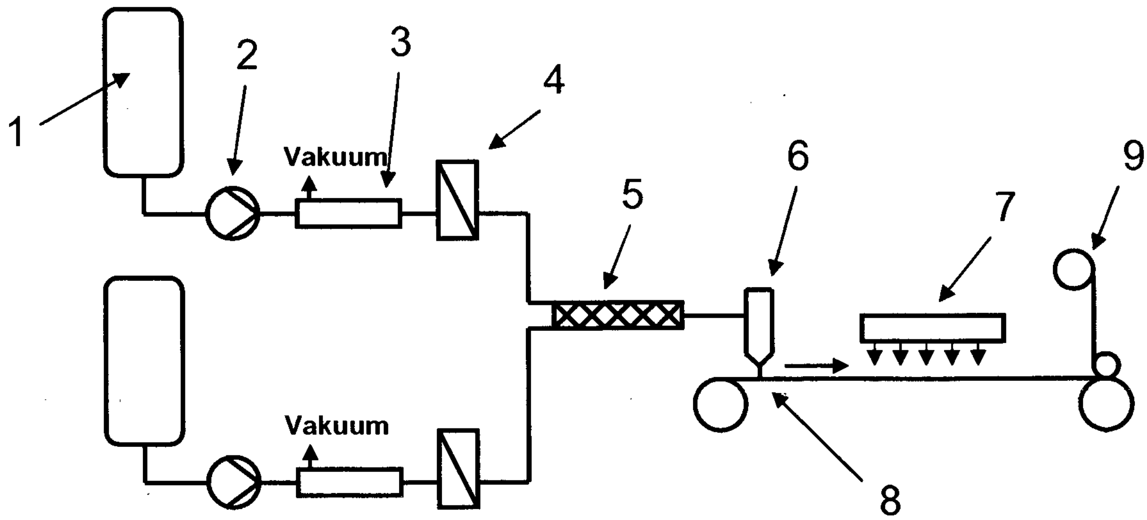

**Figur 3:**

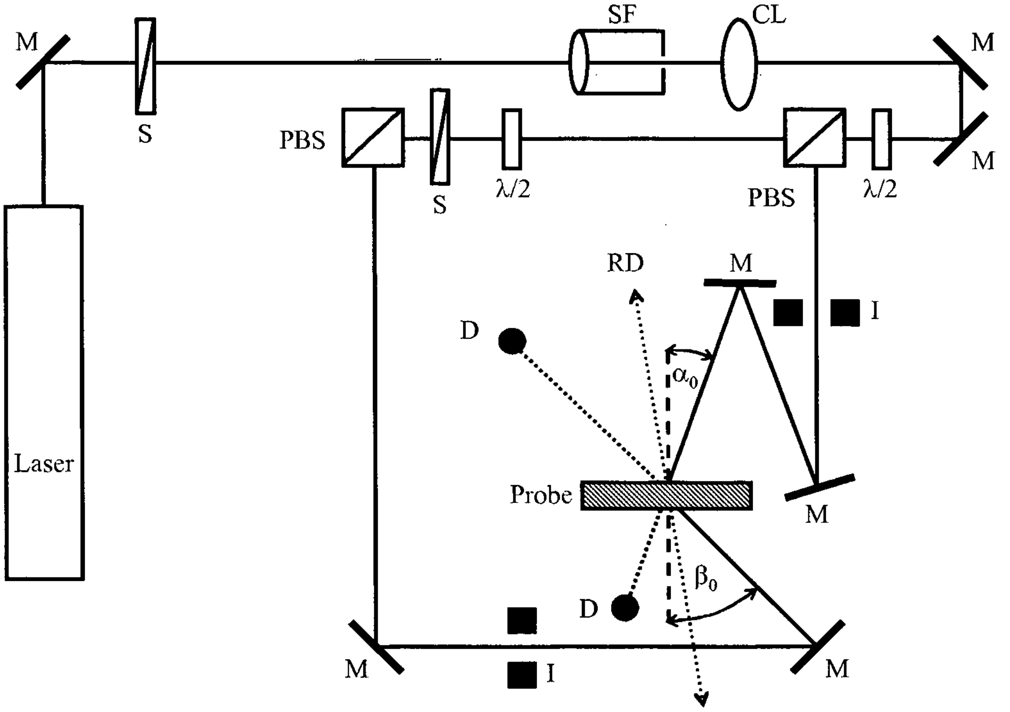


**Figur 4:**

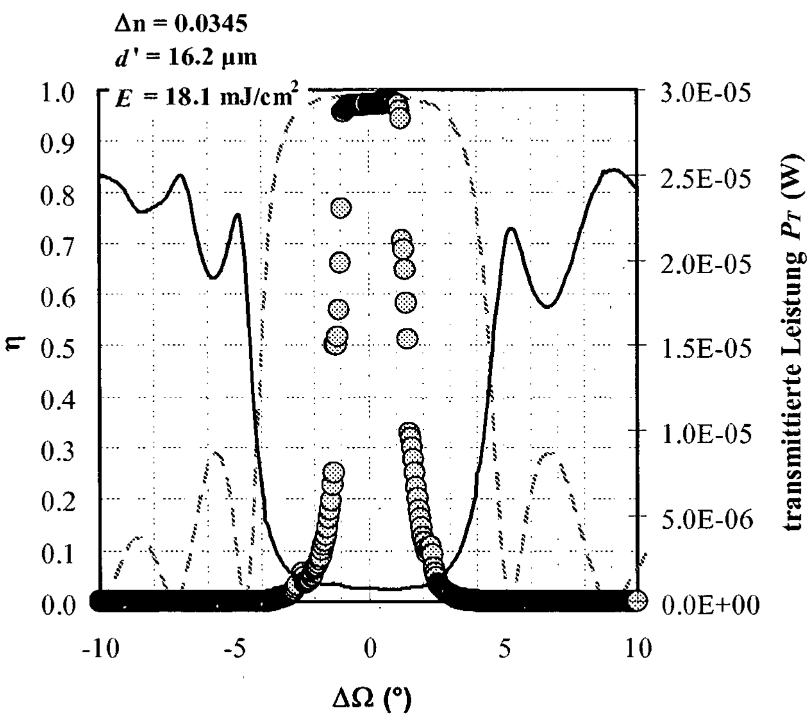

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125199 A1
- EP 09001952 A
- WO 2008125229 A1
- EP 09009651 A
- EP 09002180 A
- EP 700949 A


### In der Beschreibung aufgeführte Nicht-Patentliteratur


- **P. HARIHARAN.** Optical Holography. Cambridge University Press, 1996
- **H. KOGELNIK.** *The Bell System Technical Journal,* November 1969, vol. 48 (9), 2909, 2947